# EUROPEAN PATENT APPLICATION

(11) **EP 4 439 083 A1**
(43) Date of publication of application: **02.10.2024**
(21) Application number: 23165430.2
(22) Date of filing: 30.03.2023
(51) Int. Cl.: G01R 15/18, H05K 1/18, H01F 27/06

(54) **CURRENT SENSING DEVICE**

(71) Applicant: ABB SCHWEIZ AG, 5400 Baden (CH)
(72) Inventor: HOZOI, Adrian, 68219 Mannheim (DE); PODZEMNY, Jaromir, 621 00 Brno (CZ)
(74) Representative: Maiwald GmbH

(57) **Abstract**

The present invention relates to a current sensing device, comprising: a substrate (40); and one or more coil elements (30). The substrate comprises a plurality of holes (100) projecting at least part way through the substrate from a first surface of the substrate, wherein prior to a coil element being mounted to the substrate each of the plurality holes has a circular or polygonal cross section. The coil element comprises: a winding body (10, 20); a length of wire (80); and a plurality of locating pins (60). The winding body has an outer surface around an axis of the winding body, and wherein at least a portion of the length of wire is wound multiple times around the outer surface of the winding body in a generally circumferential direction with respect to the axis of the winding body. A first locating pin of the plurality of locating pins projects from the coil element in a direction parallel to a pin axis that is perpendicular to the axis of the winding body, and wherein a second locating pin of the plurality of locating pins projects from the coil element in the direction parallel to the pin axis. Prior to the coil element being mounted to the substrate a cross section of the first locating pin perpendicular to the pin axis comprises first and second outer vertices facing away from the second locating pin, and a cross section of the second locating pin perpendicular to the pin axis comprises third and fourth outer vertices facing away from the first locating pin, and wherein the four outer vertices form a first quadrangle. When the coil element is mounted to the first surface of the substrate the first locating pin is located in a first hole of the plurality of holes such that the first and second outer vertices are in contact with first and second regions on the inside of the first hole and the second locating pin is located in a second hole of the plurality of holes such that the third and fourth outer vertices are in contact with third and fourth regions on the inside of the second hole. Prior to the coil element being mounted to the substrate, first and second circumferential or perimeter points of the first circular or polygonal cross section hole correlate with the first and second regions, and third and fourth circumferential or perimeter points of the second circular or polygonal cross section hole correlate with the third and fourth regions, and wherein the four circumferential or perimeter points form a second quadrangle smaller than the first quadrangle.

## Description

### FIELD OF THE INVENTION

The present invention relates to current sensing devices and methods of manufacturing current sensing devices.

### BACKGROUND OF THE INVENTION

Current sensing devices comprising one or more coil elements have been receiving increasing interest in the last decades. A coil element comprises a bobbin and a winding segment applied on a winding body of the bobbin which is non-magnetic and non-conductive, where the winding segment is formed from a length of wire wound around a central axis of the winding body. A current sensing device can have just one coil element, however a current sensing device can have a plurality of coil elements. In such a current sensing device with a plurality of coil elements, a common form is the Rogowski coil configuration, where the coil elements are arranged to form an approximately closed path around an opening foreseen for a conductor and are connected electrically to sum their signals and to provide a measurement voltage of the device, which is indicative of the current in the conductor.

US9664711 B2 describes placing the bobbin elements into cavities or slots of a plastic carrier and using alignment posts to facilitate individual placement of the bobbin elements within an encapsulating header. However, this does not provide for precise and economical positioning of the bobbin elements on substrates, and also has no consideration to do so on simple substrates like PCBs.

It is also known to mount coil elements on a PCB using basic component placement concepts, not optimized for high positioning precision. EP0209415B1 describes mounting a plurality of coil elements on a PCB, where fixing of a coil element is implicitly achieved through its electrical connecting pins. Significant clearance is needed between a connecting pin and a mating PCB hole to reduce the risk to stress the pin during mating and to ensure that the electrical connection or the winding wire connected to the pin is not severed or cut. However, this placement of coil elements on a PCB using a basic component placement concept results in limited positioning precision.

There is a need to address these issues.

### SUMMARY OF THE INVENTION

Therefore, it would be advantageous to have an improved current sensing device.

The object of the present invention is solved with the subject matter of the independent claims, wherein further embodiments are incorporated in the dependent claims.

In a first aspect, there is provided a current sensing device, comprising:
- a substrate; and
- one or more coil elements.

The substrate comprises a plurality of holes projecting at least part way through the substrate from a first surface of the substrate. Prior to a coil element being mounted to the substrate each of the plurality holes has a circular or polygonal cross section. The coil element comprises:
- a winding body; a length of wire; and
- a plurality of locating pins.

The winding body has an outer surface around an axis of the winding body, at least a portion of the length of wire is wound multiple times around the outer surface of the winding body in a generally circumferential direction with respect to the axis of the winding body. A first locating pin of the plurality of locating pins projects from the coil element in a direction parallel to a pin axis that is perpendicular to the axis of the winding body. A second locating pin of the plurality of locating pins projects from the coil element in the direction parallel to the pin axis. Prior to the coil element being mounted to the substrate a cross section of the first locating pin perpendicular to the pin axis comprises first and second outer vertices facing away from the second locating pin, and a cross section of the second locating pin perpendicular to the pin axis comprises third and fourth outer vertices facing away from the first locating pin. The four outer vertices form a first quadrangle. When the coil element is mounted to the first surface of the substrate the first locating pin is located in a first hole of the plurality of holes such that the first and second outer vertices are in contact with first and second regions on the inside of the first hole and the second locating pin is located in a second hole of the plurality of holes such that the third and fourth outer vertices are in contact with third and fourth regions on the inside of the second hole. Prior to the coil element being mounted to the substrate, first and second circumferential or perimeter points of the first circular or polygonal cross section hole correlate with the first and second regions, and third and fourth circumferential or perimeter points of the second circular or polygonal cross section hole correlate with the third and fourth regions. The four circumferential or perimeter points form a second quadrangle smaller than the first quadrangle.

Here, a circumferential point refers to a circular cross-section hole, and a perimeter points refers to a polygonal cross-section hole.

In an example, a third locating pin of the plurality of locating pins projects from the coil element in the direction parallel to the pin axis. Prior to the coil element being mounted to the substrate a cross section of the third locating pin perpendicular to the pin axis comprises fifth and sixth outer vertices facing away from the first locating pin, and the first and second and fifth and sixth outer vertices form a third quadrangle. When the coil element is mounted to the first surface of the substrate the third locating pin is located in a third hole of the plurality of holes such that the fifth and sixth outer vertices are in contact with fifth and sixth regions on the inside of the third hole. Prior to the coil element being mounted to the substrate fifth and sixth circumferential or perimeter points of the third circular or polygonal cross section hole correlate with the fifth and sixth regions. The first and second and fifth and sixth circumferential or perimeter points form a fourth quadrangle smaller than the third quadrangle.

In an example, a third locating pin of the plurality of locating pins projects from the coil element in the direction parallel to the pin axis. Prior to the coil element being mounted to the substrate a cross section of the third locating pin perpendicular to the pin axis comprises a fifth outer vertex facing away from the first locating pin. The first and second and fifth outer vertices form a first triangle. When the coil element is mounted to the first surface of the substrate the third locating pin is located in a third hole of the plurality of holes such that the fifth outer vertex is in contact with a fifth region on the inside of the third hole. Prior to the coil element being mounted to the substrate a fifth circumferential or perimeter point of the third circular or polygonal cross section hole correlates with the fifth region, and the first and second and fifth circumferential or perimeter points form a second triangle smaller than the first quadrangle.

In an example, the coil element comprises two flanges located at either end of the winding body, and when the coil element is mounted to the first surface of the substrate at least a portion of each of the two flanges is in contact with the first surface of the substrate.

In an example, each flange comprises two supporting edges at opposite ends of one side of the flange, and when the coil element is mounted to the first surface of the substrate the two supporting edges of each flange are in contact with the first surface of the substrate.

In an example, the first locating pin of the plurality of locating pins is connected to or part of a first flange of the two flanges, and the second locating pin of the plurality of locating pins is connected to or part of a second flange of the two flanges.

In an example, the first flange comprises at least one recessed portion adjacent to the first locating pin, and the second flange comprises at least one recessed portion adjacent to the second locating pin. A surface of the flange within the recessed portion of each flange facing the first surface of the substrate is spaced from the first surface of the substrate.

In an example, the current sensing device further comprises a second substrate, and the second substrate comprises a one or more holes projecting at least part way through the second substrate from a first surface of the second substrate. Prior to the coil element being mounted to the second substrate each of the one or more holes has a circular or polygonal cross section. One or more further locating pins of the plurality of locating pins project from the coil element in the direction parallel to the pin axis. When the coil element is mounted to the first surface of the substrate and mounted to the first surface of the second substrate the first surface of the substrate faces the first surface of the second substrate and the coil element is located between the substrate and the second substrate and the one or more further locating pins are located in the one or more holes of the second substrate.

In an example, when the coil element is mounted to the first surface of the substrate the first locating pin and the second locating pin have deformed the first cross section hole and the second cross section hole in the substrate.

In an example, when the coil element is mounted to the first surface of the substrate the outer vertices of the first locating pin and the second locating pin have been deformed by the first cross section hole and the second cross section hole in the substrate.

In an example, the current sensing device comprises a plurality of coil elements mounted to the substrate.

In a second aspect, there is provided a method of manufacturing a current sensing device comprising mounting the one or more coil elements to the substrate to provide the above described current sensing device of the first aspect.

In a third aspect, there is provided a current sensing device, comprising:
- a substrate; and
- one or more coil elements.

The substrate comprises a plurality of holes projecting at least part way through the substrate from a first surface of the substrate. Prior to a coil element being mounted to the substrate each of the plurality holes has a circular or polygonal cross section. The coil element comprises:
- a winding body;
- a length of wire; and
- a plurality of locating pins.

The winding body has an outer surface around an axis of the winding body, and at least a portion of the length of wire is wound multiple times around the outer surface of the winding body in a generally circumferential direction with respect to the axis of the winding body. A first locating pin of the plurality of locating pins projects from the coil element in a direction parallel to a pin axis that is perpendicular to the axis of the winding body, and a second locating pin of the plurality of locating pins projects from the coil element in the direction parallel to the pin axis. Prior to the coil element being mounted to the substrate a cross section of the first locating pin perpendicular to the pin axis comprises first and second outer vertices facing away from the second locating pin, and a cross section of the second locating pin perpendicular to the pin axis comprises a third outer vertex facing away from the first locating pin, and the three outer vertices form a first triangle. When the coil element is mounted to the first surface of the substrate the first locating pin is located in a first hole of the plurality of holes such that the first and second outer vertices are in contact with first and second regions on the inside of the first hole and the second locating pin is located in a second hole of the plurality of holes such that the third outer vertex is in contact with a third region on the inside of the second hole. Prior to the coil element being mounted to the substrate, first and second circumferential or perimeter points of the first circular or polygonal cross section hole correlate with the first and second regions, and a third circumferential or perimeter point of the second circular or polygonal cross section hole correlates with the third region, and the three circumferential or perimeter points form a second triangle smaller than the first triangle.

In a fourth aspect, there is provided a method of manufacturing a current sensing device comprising mounting the one or more coil elements to the substrate to provide the above described current sensing device of the third aspect.

In a fifth aspect, there is provided a current sensing device, comprising:
- a substrate; and
- one or more coil elements.

The substrate comprises a plurality of holes projecting at least part way through the substrate from a first surface of the substrate. Prior to a coil element being mounted to the substrate each of the plurality holes has a circular or polygonal cross section. The coil element comprises:
- a winding body;
- a length of wire; and
- a plurality of locating pins.

The winding body has an outer surface around an axis of the winding body, and at least a portion of the length of wire is wound multiple times around the outer surface of the winding body in a generally circumferential direction with respect to the axis of the winding body. A first locating pin of the plurality of locating pins projects from the coil element in a direction parallel to a pin axis that is perpendicular to the axis of the winding body, and a second locating pin of the plurality of locating pins projects from the coil element in the direction parallel to the pin axis. Prior to the coil element being mounted to the substrate a cross section of the first locating pin perpendicular to the pin axis comprises a first outer vertex facing away from the second locating pin, and a cross section of the second locating pin perpendicular to the pin axis comprises a second outer vertex facing away from the first locating pin, and the two outer vertices form a first line. When the coil element is mounted to the first surface of the substrate the first locating pin is located in a first hole of the plurality of holes such that the first outer vertex is in contact with a first region on the inside of the first hole and the second locating pin is located in a second hole of the plurality of holes such that the second outer vertex is in contact with a second region on the inside of the second hole. Prior to the coil element being mounted to the substrate, a first circumferential or perimeter point of the first circular or polygonal cross section hole correlates with the first region, and a second circumferential or perimeter point of the second circular or polygonal cross section hole correlates with the second region, and the two circumferential or perimeter points form a second line shorter than the first line.

In a sixth aspect, there is provided a method of manufacturing a current sensing device comprising mounting the one or more coil elements to the substrate to provide the above described current sensing device of the fifth aspect.

In a seventh aspect, there is provided a current sensing device, comprising:
- a substrate; and
- one or more coil elements.

The substrate comprises a plurality of holes projecting at least part way through the substrate from a first surface of the substrate. Prior to a coil element being mounted to the substrate each of the plurality holes has a circular or polygonal cross section. The coil element comprises:
- a winding body;
- a length of wire; and
- a plurality of locating pins.

The winding body has an outer surface around an axis of the winding body, and at least a portion of the length of wire is wound multiple times around the outer surface of the winding body in a generally circumferential direction with respect to the axis of the winding body. A first locating pin of the plurality of locating pins projects from the coil element in a direction parallel to a pin axis that is perpendicular to the axis of the winding body, and a second locating pin of the plurality of locating pins projects from the coil element in the direction parallel to the pin axis. Prior to the coil element being mounted to the substrate a cross section of the first locating pin perpendicular to the pin axis comprises first and second inner vertices facing toward the second locating pin, and a cross section of the second locating pin perpendicular to the pin axis comprises third and fourth inner vertices facing toward the first locating pin, and the four inner vertices form a first quadrangle. When the coil element is mounted to the first surface of the substrate the first locating pin is located in a first hole of the plurality of holes such that the first and second inner vertices are in contact with first and second regions on the inside of the first hole and the second locating pin is located in a second hole of the plurality of holes such that the third and fourth inner vertices are in contact with third and fourth regions on the inside of the second hole. Prior to the coil element being mounted to the substrate, first and second circumferential or perimeter points of the first circular or polygonal cross section hole correlate with the first and second regions, and third and fourth circumferential or perimeter points of the second circular or polygonal cross section hole correlate with the third and fourth regions, and the four circumferential or perimeter points form a second quadrangle larger than the first quadrangle.

In an eighth aspect, there is provided a method of manufacturing a current sensing device comprising mounting the one or more coil elements to the substrate to provide the above described current sensing device of the seventh aspect.

In a ninth aspect, there is provided a current sensing device, comprising:
- a substrate; and
- one or more coil elements.

The substrate comprises a plurality of holes projecting at least part way through the substrate from a first surface of the substrate. Prior to a coil element being mounted to the substrate each of the plurality holes has a circular or polygonal cross section. The coil element comprises:
- a winding body;
- a length of wire; and
- a plurality of locating pins.

The winding body has an outer surface around an axis of the winding body, and at least a portion of the length of wire is wound multiple times around the outer surface of the winding body in a generally circumferential direction with respect to the axis of the winding body. A first locating pin of the plurality of locating pins projects from the coil element in a direction parallel to a pin axis that is perpendicular to the axis of the winding body, and a second locating pin of the plurality of locating pins projects from the coil element in the direction parallel to the pin axis. Prior to the coil element being mounted to the substrate a cross section of the first locating pin perpendicular to the pin axis comprises first and second inner vertices facing toward the second locating pin, and a cross section of the second locating pin perpendicular to the pin axis comprises a third inner vertex facing toward the first locating pin, and the three inner vertices form a first triangle. When the coil element is mounted to the first surface of the substrate the first locating pin is located in a first hole of the plurality of holes such that the first and second inner vertices are in contact with first and second regions on the inside of the first hole and the second locating pin is located in a second hole of the plurality of holes such that the third inner vertex is in contact with a third region on the inside of the second hole. Prior to the coil element being mounted to the substrate, first and second circumferential or perimeter points of the first circular or polygonal cross section hole correlate with the first and second regions, and a third circumferential or perimeter point of the second circular or polygonal cross section hole correlates with the third region, and the three circumferential or perimeter points form a second triangle larger than the first triangle.

In a tenth aspect, there is provided a method of manufacturing a current sensing device comprising mounting the one or more coil elements to the substrate to provide the above described current sensing device of the ninth aspect.

In an eleventh aspect, there is provided a current sensing device, comprising:
- a substrate; and
- one or more coil elements;

The substrate comprises a plurality of holes projecting at least part way through the substrate from a first surface of the substrate. Prior to a coil element being mounted to the substrate each of the plurality holes has a circular or polygonal cross section. The coil element comprises:
- a winding body;
- a length of wire; and
- a plurality of locating pins.

The winding body has an outer surface around an axis of the winding body, and at least a portion of the length of wire is wound multiple times around the outer surface of the winding body in a generally circumferential direction with respect to the axis of the winding body. A first locating pin of the plurality of locating pins projects from the coil element in a direction parallel to a pin axis that is perpendicular to the axis of the winding body, and a second locating pin of the plurality of locating pins projects from the coil element in the direction parallel to the pin axis. Prior to the coil element being mounted to the substrate a cross section of the first locating pin perpendicular to the pin axis comprises a first inner vertex facing toward the second locating pin, and a cross section of the second locating pin perpendicular to the pin axis comprises a second inner vertex facing toward the first locating pin, and the two inner vertices form a first line. When the coil element is mounted to the first surface of the substrate the first locating pin is located in a first hole of the plurality of holes such that the first inner vertex is in contact with a first region on the inside of the first hole and the second locating pin is located in a second hole of the plurality of holes such that the second inner vertex is in contact with a second region on the inside of the second hole. Prior to the coil element being mounted to the substrate, a first circumferential or perimeter point of the first circular or polygonal cross section hole correlates with the first region, and a second circumferential or perimeter point of the second circular or polygonal cross section hole correlates with the second region, and the two circumferential or perimeter points form a second line longer than the first line.

In a twelfth aspect, there is provided a method of manufacturing a current sensing device comprising mounting the one or more coil elements to the substrate to provide the above described current sensing device of the eleventh aspect.

The above aspects and examples will become apparent from and be elucidated with reference to the embodiments described hereinafter.

### BRIEF DESCRIPTION OF THE DRAWINGS

Exemplary embodiments will be described in the following with reference to the following drawings:
Fig. 1 shows an exemplar current sensing device with a plurality of exemplar coil elements;
Fig. 2A shows a view of an exemplar current sensing device viewing a second surface of a substrate and where a coil element is mounted to a first surface of the substrate facing away from the viewer;
Fig. 2B shows an end view of an exemplar coil element;
Fig. 3A shows a view of an exemplar current sensing device viewing a second surface of a substrate and where a coil element is mounted to a first surface of the substrate facing away from the viewer;
Fig. 3B shows a view of an exemplar current sensing device viewing a second surface of a substrate and where a coil element is mounted to a first surface of the substrate facing away from the viewer, where one or more locating pins can be arbitrarily shaped;
Fig. 4A shows an end view of an exemplar coil element;
Fig. 4B shows a plan view, viewing downwards on the exemplar coil element of Fig. 4A;
Fig. 5 shows a view of an exemplar current sensing device viewing a second surface of a substrate and where a coil element is mounted to a first surface of the substrate facing away from the viewer, where a locating pin has rounded sharp positioning edges, and retaining holes in the substrate have a polygonal shape;
Fig. 6A shows a view of an exemplar current sensing device viewing a second surface of a substrate and where a coil element is mounted to a first surface of the substrate facing away from the viewer, with shaped locating pins;
Fig. 6B shows a view of an exemplar current sensing device viewing a second surface of a substrate and where a coil element is mounted to a first surface of the substrate facing away from the viewer, with shaped locating pins;
Fig. 7A shows a view of an exemplar current sensing device viewing a second surface of a substrate and where a coil element is mounted to a first surface of the substrate facing away from the viewer, with shaped locating pins and retaining holes of the substrate; and
Fig. 7B shows a view of an exemplar current sensing device viewing a second surface of a substrate and where a coil element is mounted to a first surface of the substrate facing away from the viewer, with shaped locating pins and retaining holes of the substrate.

### DETAILED DESCRIPTION OF EMBODIMENTS

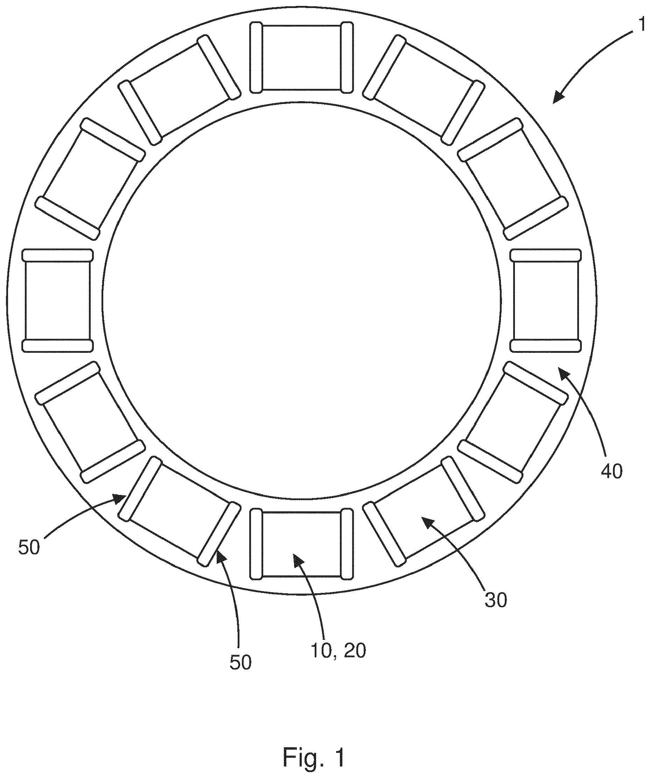

Figs. 1-7B relate to current sensing devices and methods of manufacturing current sensing devices.

In the following description, the holes 100 in the substrate 40 are described as having a circular cross section, however the holes can be polygonal in shape. All the holes can be circular, or all the holes can be polygonal shaped, or some can be circular shaped and some can be polygonal shaped.

In an example, a current sensing device comprises a substrate 40 and one or more coil elements 30. The substrate comprises a plurality of holes 100 projecting at least part way through the substrate from a first surface of the substrate. Prior to a coil element being mounted to the substrate each of the plurality holes has a circular cross section.

The holes 100 can go all the way through the substrate. The coil element comprises a winding body 10, 20, a length of wire 80, and a plurality of locating pins 60. The winding body has an outer surface around an axis of the winding body, and at least a portion of the length of wire is wound multiple times around the outer surface of the winding body in a generally circumferential direction with respect to the axis of the winding body. The wire wound in this way can be termed a winding segment. A first locating pin of the plurality of locating pins projects from the coil element in a direction parallel to a pin axis that is perpendicular to the axis of the winding body, and a second locating pin of the plurality of locating pins projects from the coil element in the direction parallel to the pin axis. Prior to the coil element being mounted to the substrate a cross section of the first locating pin perpendicular to the pin axis comprises first and second outer vertices facing away from the second locating pin, and a cross section of the second locating pin perpendicular to the pin axis comprises third and fourth outer vertices facing away from the first locating pin, and the four outer vertices form (or define) a first quadrangle. When the coil element is mounted to the first surface of the substrate the first locating pin is located in a first hole of the plurality of holes such that the first and second outer vertices are in contact with first and second regions on the inside of the first hole and the second locating pin is located in a second hole of the plurality of holes such that the third and fourth outer vertices are in contact with third and fourth regions on the inside of the second hole. Prior to the coil element being mounted to the substrate, first and second circumferential points of the first circular cross section hole correlate with the first and second regions, and third and fourth circumferential points of the second circular cross section hole correlate with the third and fourth regions, and the four circumferential points form (or define) a second quadrangle smaller than the first quadrangle.

In other words, the outer corners of the locating pins are spaced further apart than the available space provided by the holes in the substrate. When the locating pins are inserted into the substrate if a material of the locating pins is harder than that of the substrate the corners will cut into the substrate as they are inserted. Alternatively, if the material of the locating pins is softer than the material of the substrate the locating pins will slightly deform as they are pushed into the substrate. However, either way the coil element is very precisely located with respect to the holes in the substrate.

In other words, the outer edges or corners of the locating pins are forced to cut into the outer circumferential parts of the hole in the substrate due to being inserted into the holes, and this leads to accurate positioning of the locating pins in the holes and therefore accurate positioning of the coil element with respect to the holes in the substrate.

Alternatively, the locating pins can be softer than the substrate material, and the outer edges or corners of the locating pins are forced to be deformed by the outer circumferential parts of the hole in the substrate due to being inserted into the holes, and this leads to accurate positioning of the locating pins in the holes and therefore accurate positioning of the coil element with respect to the holes in the substrate

In this way, holes for locating a coil element on a substrate can be very accurate made. However, in the past when a coil element was mounted to a substrate, there was always a variation in exactly where the winding body, with wire wound around it that constitutes a wire segment, was positioned with respect to the holes, and thus signals from coil elements would vary for a current sensing device. However, now edges of the locating pins of a coil element are forced to engage with the same part of holes, and this means that the coil elements are positioned accurately and reproducibly with respect to the hole in the substrate. Thus, the coil element can be accurately positioned laterally and longitudinally on the substrate, improving consistency of signals, and where a series of coil elements are mounted on the substrate, in for example a Rogowski coil configuration, the signal from each coil element will be consistent with the signals from the other coil elements. This improves accuracy of the current sensing device and improves reproducibility of signals between current sensing devices, such that a sensing device can be replaced with a different sensing device and will provide signals consistent with the previous sensing device. Calibration data sets are often provided and may be employed for example when the sensor signal is utilized for determining electrical power and/or energy with very high accuracy. Such reference or calibration data sets can be applied to all the sensing devices and each sensing device may not need to have its own reference data set or calibration data set. Thus accuracy of the current sensing device is improved by reducing undesired influences from interfering magnetic fields from sources external to the device, and, different devices can be utilized to diagnose situations, based on signal detection, that that particular device has not been calibrated to diagnose, but can use data acquired by a different device.

In an example, the first quadrangle is a rectangle and the second quadrangle is a rectangle.

In an example, the first quadrangle is a trapezoid and the second quadrangle is a trapezoid.

According to an example, a third locating pin of the plurality of locating pins projects from the coil element in the direction parallel to the pin axis. Prior to the coil element being mounted to the substrate a cross section of the third locating pin perpendicular to the pin axis comprises fifth and sixth outer vertices facing away from the first locating pin, wherein the first and second and fifth and sixth outer vertices form (or define) a third quadrangle. When the coil element is mounted to the first surface of the substrate the third locating pin is located in a third hole of the plurality of holes such that the fifth and sixth outer vertices are in contact with fifth and sixth regions on the inside of the third hole. Prior to the coil element being mounted to the substrate fifth and sixth circumferential points of the third circular cross section hole correlate with the fifth and sixth regions, and the first and second and fifth and sixth circumferential points form (or define) a fourth quadrangle smaller than the third quadrangle.

According to an example, a third locating pin of the plurality of locating pins projects from the coil element in the direction parallel to the pin axis. Prior to the coil element being mounted to the substrate a cross section of the third locating pin perpendicular to the pin axis comprises a fifth outer vertex facing away from the first locating pin, and the first and second and fifth outer vertices form (or define) a first triangle. When the coil element is mounted to the first surface of the substrate the third locating pin is located in a third hole of the plurality of holes such that the fifth outer vertex is in contact with a fifth region on the inside of the third hole. Prior to the coil element being mounted to the substrate a fifth circumferential point of the third circular cross section hole correlates with the fifth region, and the first and second and fifth circumferential points form (or define) a second triangle smaller than the first quadrangle.

In an example, the substrate is a printed circuit board (PCB).

According to an example, the coil element comprises two flanges 50 located at either end of the winding body, and when the coil element is mounted to the first surface of the substrate at least a portion 110 of each of the two flanges is in contact with the first surface of the substrate.

In this way a predetermined distance of the winding body and wire with respect to the substrate can be ensured.

In an example, each flange is arranged perpendicular to the axis of the winding body.

According to an example, each flange comprises two supporting edges 110 at opposite ends of one side of the flange, and when the coil element is mounted to the first surface of the substrate the two supporting edges of each flange are in contact with the first surface of the substrate.

In this way, the supporting edges support the coil element on the substrate and ensure a predetermined spacing between the winding body, upon which the wire has been wound, the wound wire can also be termed a winding segment, and the substrate. Thus, the coil element can be accurately positioned vertically with respect to the substrate, improving consistency of signals, and where a series of coil elements are mounted on the substrate, in for example a Rogowski coil configuration, the signal from each coil element will be consistent with the signals from the other coil elements. This improves accuracy of the current sensing device and improves reproducibility of signals between current sensing devices, such that a sensing device can be replaced with a different sensing device and will provide signals consistent with the previous sensing device, and reference or calibration data sets can be applied to all the sensing devices and each sensing device does not need to have its own reference data set or calibration data set. Thus, different devices can be utilized to diagnose situations, based on signal detection, that that particular device has not been calibrated to diagnose, but can use data acquired by a different device.

According to an example, the first locating pin of the plurality of locating pins is connected to or part of a first flange of the two flanges, and the second locating pin of the plurality of locating pins is connected to or part of a second flange of the two flanges.

Thus, economic and reproducible manufacturability is provided.

In an example, the third locating pin is connected to or part of the second flange.

According to an example, the first flange comprises at least one recessed portion 120 adjacent to the first locating pin, and the second flange comprises at least one recessed portion 120 adjacent to the second locating pin. A surface of the flange within the recessed portion of each flange facing the first surface of the substrate is spaced from the first surface of the substrate.

The recess enables a locating pin to bend and/or deform more than it could if there was no recess. This addresses the issues of manufacturing errors or tolerances, providing for reliable and economic manufacturability.

According to an example, the current sensing device further comprises a second substrate. The second substrate comprises a one or more holes projecting at least part way through the second substrate from a first surface of the second substrate, and prior to the coil element being mounted to the second substrate each of the one or more holes has a circular cross section. The one or more holes in the second substrate can go all the way through the second substrate. One or more further locating pins of the plurality of locating pins project from the coil element in the direction parallel to the pin axis. When the coil element is mounted to the first surface of the substrate and mounted to the first surface of the second substrate the first surface of the substrate faces the first surface of the second substrate and the coil element is located between the substrate and the second substrate and the one or more further locating pins are located in the one or more holes of the second substrate.

Using a second substrate, such as a PCB, provides further improved stability and precision for the positioning of the coil element or elements.

In an example, a first locating pin of the one or more further locating pins is connected to or part of the first flange.

In an example, the one or more circular cross section holes of the second substrate are a plurality of circular cross section holes, and the one or more further locating pins are a plurality of further locating pins, and a second locating pin of the one or more further locating pins is connected to or part of the second flange.

According to an example, when the coil element is mounted to the first surface of the substrate the first locating pin and the second locating pin have deformed the first cross section hole and the second cross section hole in the substrate.

According to an example, when the coil element is mounted to the first surface of the substrate the outer vertices of the first locating pin and the second locating pin have been deformed by the first cross section hole and the second cross section hole in the substrate.

According to an example, the current sensing device comprises a plurality of coil elements mounted to the substrate.

Each of the coil elements can be configured as described above with respect to the above described coil element and mounted to the substrate as described above for the coil element.

In an example, the current sensing device is configured as a Rogowski coil.

From the above description of this current sensing device, in its different possible examples, a clear teaching is provided regarding a method of manufacturing such a current sensing device, in its different examples.

In an example, a current sensing device comprises a substrate 40, and one or more coil elements 30. The substrate comprises a plurality of holes 100 projecting at least part way through the substrate from a first surface of the substrate, and prior to a coil element being mounted to the substrate each of the plurality holes has a circular cross section. The one or more holes can go all the way through the substrate. The coil element comprises a winding body 10, 20, a length of wire 80, and a plurality of locating pins 60. The winding body has an outer surface around an axis of the winding body, and at least a portion of the length of wire is wound multiple times around the outer surface of the winding body in a generally circumferential direction with respect to the axis of the winding body. The wire wound in this way can be termed a winding segment. A first locating pin of the plurality of locating pins projects from the coil element in a direction parallel to a pin axis that is perpendicular to the axis of the winding body, and a second locating pin of the plurality of locating pins projects from the coil element in the direction parallel to the pin axis. Prior to the coil element being mounted to the substrate a cross section of the first locating pin perpendicular to the pin axis comprises first and second outer vertices facing away from the second locating pin, and a cross section of the second locating pin perpendicular to the pin axis comprises a third outer vertex facing away from the first locating pin, and the three outer vertices form (or define) a first triangle. When the coil element is mounted to the first surface of the substrate the first locating pin is located in a first hole of the plurality of holes such that the first and second outer vertices are in contact with first and second regions on the inside of the first hole and the second locating pin is located in a second hole of the plurality of holes such that the third outer vertex is in contact with a third region on the inside of the second hole. Prior to the coil element being mounted to the substrate, first and second circumferential points of the first circular cross section hole correlate with the first and second regions, and a third circumferential point of the second circular cross section hole correlates with the third region, and the three circumferential points form (or define) a second triangle smaller than the first triangle.

Thus, rather than having two "square" or "rectangular" shaped locating pins that are spaced further apart than the holed in the substrate, one locating pin can be square or rectangular and one can be triangular.

In an example, a third locating pin of the plurality of locating pins projects from the coil element in the direction parallel to the pin axis. Prior to the coil element being mounted to the substrate a cross section of the third locating pin perpendicular to the pin axis comprises fourth and fifth outer vertices facing away from the first locating pin, and the first and second and fourth and fifth outer vertices form (or define) a first quadrangle. When the coil element is mounted to the first surface of the substrate the third locating pin is located in a third hole of the plurality of holes such that the fourth and fifth outer vertices are in contact with fourth and fifth regions on the inside of the third hole. Prior to the coil element being mounted to the substrate fourth and fifth circumferential points of the third circular cross section hole correlate with the fourth and fifth regions, and the first and second and fourth and fifth circumferential points form (or define) a second quadrangle smaller than the first quadrangle.

In an example, the first and second quadrangles are trapezoids.

In an example, the first and second quadrangles are rectangles.

In an example, a third locating pin of the plurality of locating pins projects from the coil element in the direction parallel to the pin axis. Prior to the coil element being mounted to the substrate a cross section of the third locating pin perpendicular to the pin axis comprises a fourth outer vertex facing away from the first locating pin, and the first and second and fourth outer vertices form (or define) a third triangle. When the coil element is mounted to the first surface of the substrate the third locating pin is located in a third hole of the plurality of holes such that the fourth outer vertex is in contact with a fourth region on the inside of the third hole. Prior to the coil element being mounted to the substrate a fourth circumferential point of the third circular cross section hole correlates with the fourth region, and the first and second and fourth circumferential points form (or define) a fourth triangle smaller than the third quadrangle.

In an example, the substrate is a printed circuit board (PCB).

In an example, the coil element comprises two flanges 50 located at either end of the winding body, and when the coil element is mounted to the first surface of the substrate at least a portion 110 of each of the two flanges is in contact with the first surface of the substrate.

In this way a predetermined distance of the winding body and wire with respect to the substrate can be ensured.

In an example, each flange is arranged perpendicular to the axis of the winding body.

In an example, each flange comprises two supporting edges 110 at opposite ends of one side of the flange, and wherein when the coil element is mounted to the first surface of the substrate the two supporting edges of each flange are in contact with the first surface of the substrate.

In this way, the supporting edges support the coil element on the substrate and ensure a predetermined spacing between the winding body, upon which the wire has been wound, the wound wire can also be termed a winding segment, and the substrate. Thus, the coil element can be accurately positioned vertically with respect to the substrate, improving consistency of signals, and where a series of coil elements are mounted on the substrate, in for example a Rogowski coil configuration, the signal from each coil element will be consistent with the signals from the other coil elements. This improves accuracy of the current sensing device and improves reproducibility of signals between current sensing devices, such that a sensing device can be replaced with a different sensing device and will provide signals consistent with the previous sensing device, and reference or calibration data sets can be applied to all the sensing devices and each sensing device does not need to have its own reference data set or calibration data set. Thus, different devices can be utilized to diagnose situations, based on signal detection, that that particular device has not been calibrated to diagnose, but can use data acquired by a different device.

In an example, the first locating pin of the plurality of locating pins is connected to or part of a first flange of the two flanges, and the second locating pin of the plurality of locating pins is connected to or part of a second flange of the two flanges.

Thus, economic and reproducible manufacturability is provided.

In an example, the third locating pin is connected to or part of the second flange.

In an example, the first flange comprises at least one recessed portion 120 adjacent to the first locating pin, and the second flange comprises at least one recessed portion 120 adjacent to the second locating pin. A surface of the flange within the recessed portion of each flange facing the first surface of the substrate is spaced from the first surface of the substrate.

The recess enables a locating pin to bend and/or deform more than it could if there was no recess. This addresses the issues of manufacturing errors or tolerances, providing for reliable and economic manufacturability.

In an example, the current sensing device further comprises a second substrate. The second substrate comprises a one or more holes projecting at least part way through the second substrate from a first surface of the second substrate, and prior to the coil element being mounted to the second substrate each of the one or more holes has a circular cross section. The one or more holes can go all the way through the second substrate. One or more further locating pins of the plurality of locating pins project from the coil element in the direction parallel to the pin axis. When the coil element is mounted to the first surface of the substrate and mounted to the first surface of the second substrate the first surface of the substrate faces the first surface of the second substrate and the coil element is located between the substrate and the second substrate and the one or more further locating pins are located in the one or more holes of the second substrate.

Using a second substrate, such as a PCB, provides further improved stability and precision for the positioning of the coil element or elements.

In an example, a first locating pin of the one or more further locating pins is connected to or part of the first flange.

In an example, the one or more circular cross section holes of the second substrate are a plurality of circular cross section holes, and the one or more further locating pins are a plurality of further locating pins, and a second locating pin of the one or more further locating pins is connected to or part of the second flange.

In an example, when the coil element is mounted to the first surface of the substrate the first locating pin and the second locating pin have deformed the first cross section hole and the second cross section hole in the substrate.

In an example, when the coil element is mounted to the first surface of the substrate the outer vertices of the first locating pin and the second locating pin have been deformed by the first cross section hole and the second cross section hole in the substrate.

In an example, the current sensing device comprises a plurality of coil elements mounted to the substrate.

Each of the coil elements can be configured as described above with respect to the above described coil element and mounted to the substrate as described above for the coil element.

In an example, the current sensing device is configured as a Rogowski coil.

From the above description of this current sensing device, in its different possible examples, a clear teaching is provided regarding a method of manufacturing such a current sensing device, in its different examples.

In an example, a current sensing device, comprises a substrate 40, and one or more coil elements 30. The substrate comprises a plurality of holes 100 projecting at least part way through the substrate from a first surface of the substrate, and prior to a coil element being mounted to the substrate each of the plurality holes has a circular cross section. The holes can go all the way through the substrate. The coil element comprises a winding body 10, 20, a length of wire 80, and a plurality of locating pins 60. The winding body has an outer surface around an axis of the winding body, and at least a portion of the length of wire is wound multiple times around the outer surface of the winding body in a generally circumferential direction with respect to the axis of the winding body. The wire wound in this way can be termed a winding segment. A first locating pin of the plurality of locating pins projects from the coil element in a direction parallel to a pin axis that is perpendicular to the axis of the winding body, and a second locating pin of the plurality of locating pins projects from the coil element in the direction parallel to the pin axis. Prior to the coil element being mounted to the substrate a cross section of the first locating pin perpendicular to the pin axis comprises a first outer vertex facing away from the second locating pin, and a cross section of the second locating pin perpendicular to the pin axis comprises a second outer vertex facing away from the first locating pin, and the two outer vertices form (or define) a first line. When the coil element is mounted to the first surface of the substrate the first locating pin is located in a first hole of the plurality of holes such that the first outer vertex is in contact with a first region on the inside of the first hole and the second locating pin is located in a second hole of the plurality of holes such that the second outer vertex is in contact with a second region on the inside of the second hole. Prior to the coil element being mounted to the substrate, a first circumferential point of the first circular cross section hole correlates with the first region, and a second circumferential point of the second circular cross section hole correlates with the second region, and the two circumferential points form (or define) a second line shorter than the first line.

In other words, before the coil element is inserted into the substrate a distance between outer extents of the two location pins are spaced apart by a distance greater than the maximum separation of the outer circumferences of the two holes in the substrate,

Thus, rather than having two "square" or "rectangular" shaped locating pins that are spaced further apart than the holed in the substrate, of having one of those two locating pins in a triangular form, both could be triangular with an apex pointing outwards and only the apex of both triangles engaging with the holes in the substrate.

In an example, a third locating pin of the plurality of locating pins projects from the coil element in the direction parallel to the pin axis. Prior to the coil element being mounted to the substrate a cross section of the third locating pin perpendicular to the pin axis comprises third and fourth outer vertices facing away from the first locating pin, and the first and third and fourth outer vertices form (or define) a first triangle. When the coil element is mounted to the first surface of the substrate the third locating pin is located in a third hole of the plurality of holes such that the third and fourth outer vertices are in contact with third and fourth regions on the inside of the third hole. Prior to the coil element being mounted to the substrate third and fourth circumferential points of the third circular cross section hole correlate with the third and fourth regions, wherein the first and third and fourth circumferential points form a second triangle smaller than the first triangle.

In an example, a third locating pin of the plurality of locating pins projects from the coil element in the direction parallel to the pin axis. Prior to the coil element being mounted to the substrate a cross section of the third locating pin perpendicular to the pin axis comprises a third outer vertex facing away from the first locating pin, and the first and third outer vertices form (or define) a third line. When the coil element is mounted to the first surface of the substrate the third locating pin is located in a third hole of the plurality of holes such that the third outer vertex is in contact with a third region on the inside of the third hole. Prior to the coil element being mounted to the substrate a third circumferential point of the third circular cross section hole correlates with the third region, and the first and third circumferential points form a fourth line shorter than the third line.

In an example, the substrate is a printed circuit board (PCB).

In an example, the coil element comprises two flanges 50 located at either end of the winding body, and when the coil element is mounted to the first surface of the substrate at least a portion 110 of each of the two flanges is in contact with the first surface of the substrate.

In this way a predetermined distance of the winding body and wire with respect to the substrate can be ensured.

In an example, each flange is arranged perpendicular to the axis of the winding body.

In an example, each flange comprises two supporting edges 110 at opposite ends of one side of the flange, and when the coil element is mounted to the first surface of the substrate the two supporting edges of each flange are in contact with the first surface of the substrate.

In this way, the supporting edges support the coil element on the substrate and ensure a predetermined spacing between the winding body, upon which the wire has been wound, the wound wire can also be termed a winding segment, and the substrate. Thus, the coil element can be accurately positioned vertically with respect to the substrate, improving consistency of signals, and where a series of coil elements are mounted on the substrate, in for example a Rogowski coil configuration, the signal from each coil element will be consistent with the signals from the other coil elements. This improves accuracy of the current sensing device and improves reproducibility of signals between current sensing devices, such that a sensing device can be replaced with a different sensing device and will provide signals consistent with the previous sensing device, and reference or calibration data sets can be applied to all the sensing devices and each sensing device does not need to have its own reference data set or calibration data set. Thus, different devices can be utilized to diagnose situations, based on signal detection, that that particular device has not been calibrated to diagnose, but can use data acquired by a different device.

In an example, the first locating pin of the plurality of locating pins is connected to or part of a first flange of the two flanges, and the second locating pin of the plurality of locating pins is connected to or part of a second flange of the two flanges.

Thus, economic and reproducible manufacturability is provided.

In an example, the third locating pin is connected to or part of the second flange.

In an example, the first flange comprises at least one recessed portion 120 adjacent to the first locating pin, and the second flange comprises at least one recessed portion 120 adjacent to the second locating pin, and a surface of the flange within the recessed portion of each flange facing the first surface of the substrate is spaced from the first surface of the substrate.

The recess enables a locating pin to bend and/or deform more than it could if there was no recess. This addresses the issues of manufacturing errors or tolerances, providing for reliable and economic manufacturability.

In an example, the current sensing device comprises a second substrate. The second substrate comprises a one or more holes projecting at least part way through the second substrate from a first surface of the second substrate, and prior to the coil element being mounted to the second substrate each of the one or more holes has a circular cross section. One or more further locating pins of the plurality of locating pins project from the coil element in the direction parallel to the pin axis. When the coil element is mounted to the first surface of the substrate and mounted to the first surface of the second substrate the first surface of the substrate faces the first surface of the second substrate and the coil element is located between the substrate and the second substrate and the one or more further locating pins are located in the one or more circular cross section holes of the second substrate.

Using a second substrate, such as a PCB, provides further improved stability and precision for the positioning of the coil element or elements.

In an example, a first locating pin of the one or more further locating pins is connected to or part of the first flange.

In an example, the one or more circular cross section holes of the second substrate are a plurality of circular cross section holes, and the one or more further locating pins are a plurality of further locating pins, and a second locating pin of the one or more further locating pins is connected to or part of the second flange.

In an example, when the coil element is mounted to the first surface of the substrate the first locating pin and the second locating pin have deformed the first cross section hole and the second cross section hole in the substrate.

In an example, when the coil element is mounted to the first surface of the substrate the outer vertices of the first locating pin and the second locating pin have been deformed by the first cross section hole and the second cross section hole in the substrate.

In an example, the current sensing device comprises a plurality of coil elements mounted to the substrate.

Each of the coil elements can be configured as described above with respect to the above described coil element and mounted to the substrate as described above for the coil element.

In an example, the current sensing device is configured as a Rogowski coil.

From the above description of this current sensing device, in its different possible examples, a clear teaching is provided regarding a method of manufacturing such a current sensing device, in its different examples.

In an example, a current sensing device comprises a substrate 40, and one or more coil elements 30. The substrate comprises a plurality of holes 100 projecting at least part way through the substrate from a first surface of the substrate, and prior to a coil element being mounted to the substrate each of the plurality holes has a circular cross section. The coil element comprises a winding body 10, 20, a length of wire 80, and a plurality of locating pins 60. The winding body has an outer surface around an axis of the winding body, and at least a portion of the length of wire is wound multiple times around the outer surface of the winding body in a generally circumferential direction with respect to the axis of the winding body. The wound wire forms what can be termed a winding segment. A first locating pin of the plurality of locating pins projects from the coil element in a direction parallel to a pin axis that is perpendicular to the axis of the winding body, and a second locating pin of the plurality of locating pins projects from the coil element in the direction parallel to the pin axis. Prior to the coil element being mounted to the substrate a cross section of the first locating pin perpendicular to the pin axis comprises first and second inner vertices facing toward the second locating pin, and a cross section of the second locating pin perpendicular to the pin axis comprises third and fourth inner vertices facing toward the first locating pin, and wherein the four inner vertices form (or define) a first quadrangle. When the coil element is mounted to the first surface of the substrate the first locating pin is located in a first hole of the plurality of holes such that the first and second inner vertices are in contact with first and second regions on the inside of the first hole and the second locating pin is located in a second hole of the plurality of holes such that the third and fourth inner vertices are in contact with third and fourth regions on the inside of the second hole. Prior to the coil element being mounted to the substrate, first and second circumferential points of the first circular cross section hole correlate with the first and second regions, and third and fourth circumferential points of the second circular cross section hole correlate with the third and fourth regions, and the four circumferential points form (or define) a second quadrangle larger than the first quadrangle.

In other words, the inner corners of the locating pins are spaced closer than the available space provided by the holes in the substrate. when the locating pins are inserted into the substrate if a material of the locating pins is harder than that of the substrate the corners will cut into the substrate as they are inserted. Alternatively, if the material of the locating pins is sifter than the material of the substrate the locating pins will slightly deform as they are pushed into the substrate. However, either way the coil element is very precisely located with respect to the holes in the substrate.

In other words, the inner edges or corners of the locating pins are forced to cut into the inner circumferential parts of the hole in the substrate due to being inserted into the holes, and this leads to accurate positioning of the locating pins in the holes and therefore accurate positioning of the coil element with respect to the holes in the substrate.

Alternatively, the locating pins can be softer than the substrate material, and the inner edges or corners of the locating pins are forced to be deformed by the inner circumferential parts of the hole in the substrate due to being inserted into the holes, and this leads to accurate positioning of the locating pins in the holes and therefore accurate positioning of the coil element with respect to the holes in the substrate

In this way, holes for locating a coil element on a substrate can be very accurate made. However, in the past when a coil element was mounted to a substrate, there was always a variation in exactly where the winding body, with wire wound around it that constitutes a wire segment, was positioned with respect to the holes, and thus signals from coil elements would vary for a current sensing device. However, now edges of the locating pins of a coil element are forced to engage with the same part of holes, and this means that the coil elements are positioned accurately and reproducibly with respect to the hole in the substrate. Thus, the coil element can be accurately positioned laterally on the substrate, improving consistency of signals, and where a series of coil elements are mounted on the substrate, in for example a Rogowski coil configuration, the signal from each coil element will be consistent with the signals from the other coil elements. This improves accuracy of the current sensing device and improves reproducibility of signals between current sensing devices, such that a sensing device can be replaced with a different sensing device and will provide signals consistent with the previous sensing device, and reference or calibration data sets can be applied to all the sensing devices and each sensing device does not need to have its own reference data set or calibration data set. Thus, different devices can be utilized to diagnose situations, based on signal detection, that that particular device has not been calibrated to diagnose, but can use data acquired by a different device.

In an example, the first quadrangle is a rectangle and the second quadrangle is a rectangle.

In an example, the first quadrangle is a trapezoid and the second quadrangle is a trapezoid.

In an example, a third locating pin of the plurality of locating pins projects from the coil element in the direction parallel to the pin axis. Prior to the coil element being mounted to the substrate a cross section of the third locating pin perpendicular to the pin axis comprises fifth and sixth inner vertices facing toward the first locating pin, and the first and second and fifth and sixth inner vertices form (or define) a third quadrangle. When the coil element is mounted to the first surface of the substrate the third locating pin is located in a third hole of the plurality of holes such that the fifth and sixth inner vertices are in contact with fifth and sixth regions on the inside of the third hole. Prior to the coil element being mounted to the substrate fifth and sixth circumferential points of the third circular cross section hole correlate with the fifth and sixth regions, and the first and second and fifth and sixth circumferential points form (or define) a fourth quadrangle larger than the third quadrangle.

In an example, a third locating pin of the plurality of locating pins projects from the coil element in the direction parallel to the pin axis. Prior to the coil element being mounted to the substrate a cross section of the third locating pin perpendicular to the pin axis comprises a fifth inner vertex facing toward the first locating pin, and the first and second and fifth inner vertices form (or define) a first triangle. When the coil element is mounted to the first surface of the substrate the third locating pin is located in a third hole of the plurality of holes such that the fifth inner vertex is in contact with a fifth region on the inside of the third hole. Prior to the coil element being mounted to the substrate a fifth circumferential point of the third circular cross section hole correlates with the fifth region, and the first and second and fifth circumferential points form (or define) a second triangle larger than the first quadrangle.

In an example, the substrate is a printed circuit board (PCB).

In an example, the coil element comprises two flanges 50 located at either end of the winding body, and when the coil element is mounted to the first surface of the substrate at least a portion 110 of each of the two flanges is in contact with the first surface of the substrate.

In this way a predetermined distance of the winding body and wire with respect to the substrate can be ensured.

In an example, each flange is arranged perpendicular to the axis of the winding body.

In an example, each flange comprises two supporting edges 110 at opposite ends of one side of the flange, and when the coil element is mounted to the first surface of the substrate the two supporting edges of each flange are in contact with the first surface of the substrate.

In this way, the supporting edges support the coil element on the substrate and ensure a predetermined spacing between the winding body, upon which the wire has been wound, the wound wire can also be termed a winding segment, and the substrate. Thus, the coil element can be accurately positioned vertically with respect to the substrate, improving consistency of signals, and where a series of coil elements are mounted on the substrate, in for example a Rogowski coil configuration, the signal from each coil element will be consistent with the signals from the other coil elements. This improves accuracy of the current sensing device and improves reproducibility of signals between current sensing devices, such that a sensing device can be replaced with a different sensing device and will provide signals consistent with the previous sensing device, and reference or calibration data sets can be applied to all the sensing devices and each sensing device does not need to have its own reference data set or calibration data set. Thus, different devices can be utilized to diagnose situations, based on signal detection, that that particular device has not been calibrated to diagnose, but can use data acquired by a different device.

In an example, the first locating pin of the plurality of locating pins is connected to or part of a first flange of the two flanges, and the second locating pin of the plurality of locating pins is connected to or part of a second flange of the two flanges.

Thus, economic and reproducible manufacturability is provided.

In an example, the third locating pin is connected to or part of the second flange.

In an example, the first flange comprises at least one recessed portion 120 adjacent to the first locating pin, and the second flange comprises at least one recessed portion 120 adjacent to the second locating pin, and a surface of the flange within the recessed portion of each flange facing the first surface of the substrate is spaced from the first surface of the substrate.

The recess enables a locating pin to bend and/or deform more than it could if there was no recess. This addresses the issues of manufacturing errors or tolerances, providing for reliable and economic manufacturability.

In an example, the current sensing device further comprises a second substrate. The second substrate comprises a one or more holes projecting at least part way through the second substrate from a first surface of the second substrate. Prior to the coil element being mounted to the second substrate each of the one or more holes has a circular cross section. One or more further locating pins of the plurality of locating pins project from the coil element in the direction parallel to the pin axis. When the coil element is mounted to the first surface of the substrate and mounted to the first surface of the second substrate the first surface of the substrate faces the first surface of the second substrate and the coil element is located between the substrate and the second substrate and the one or more further locating pins are located in the one or more holes of the second substrate.

Using a second substrate, such as a PCB, provides further improved stability and precision for the positioning of the coil element or elements.

In an example, a first locating pin of the one or more further locating pins is connected to or part of the first flange.

In an example, the one or more circular cross section holes of the second substrate are a plurality of circular cross section holes, and the one or more further locating pins are a plurality of further locating pins, and a second locating pin of the one or more further locating pins is connected to or part of the second flange.

In an example, when the coil element is mounted to the first surface of the substrate the first locating pin and the second locating pin have deformed the first cross section hole and the second cross section hole in the substrate.

In an example, when the coil element is mounted to the first surface of the substrate the inner vertices of the first locating pin and the second locating pin have been deformed by the first cross section hole and the second cross section hole in the substrate.

In an example, the current sensing device comprises a plurality of coil elements mounted to the substrate.

Each of the coil elements can be configured as described above with respect to the above described coil element and mounted to the substrate as described above for the coil element.

Each of the coil elements can be configured as described above with respect to the above described coil element and mounted to the substrate as described above for the coil element.

In an example, the current sensing device is configured as a Rogowski coil.

From the above description of this current sensing device, in its different possible examples, a clear teaching is provided regarding a method of manufacturing such a current sensing device, in its different examples.

In an example, a current sensing device comprises a substrate 40, and one or more coil elements 30. The substrate comprises a plurality of holes 100 projecting at least part way through the substrate from a first surface of the substrate, and prior to a coil element being mounted to the substrate each of the plurality holes has a circular cross section. The holes can go all the way through the substrate. The coil element comprises a winding body 10, 20, a length of wire 80, and a plurality of locating pins 60. The winding body has an outer surface around an axis of the winding body, and at least a portion of the length of wire is wound multiple times around the outer surface of the winding body in a generally circumferential direction with respect to the axis of the winding body. The wound wire can be termed a winding segment. A first locating pin of the plurality of locating pins projects from the coil element in a direction parallel to a pin axis that is perpendicular to the axis of the winding body, and a second locating pin of the plurality of locating pins projects from the coil element in the direction parallel to the pin axis. Prior to the coil element being mounted to the substrate a cross section of the first locating pin perpendicular to the pin axis comprises first and second inner vertices facing toward the second locating pin, and a cross section of the second locating pin perpendicular to the pin axis comprises a third inner vertex facing toward the first locating pin, and the three inner vertices form (or define) a first triangle. When the coil element is mounted to the first surface of the substrate the first locating pin is located in a first hole of the plurality of holes such that the first and second inner vertices are in contact with first and second regions on the inside of the first hole and the second locating pin is located in a second hole of the plurality of holes such that the third inner vertex is in contact with a third region on the inside of the second hole. Prior to the coil element being mounted to the substrate, first and second circumferential points of the first circular cross section hole correlate with the first and second regions, and a third circumferential point of the second circular cross section hole correlates with the third region, and the three circumferential points form (or define) a second triangle larger than the first triangle.

Thus, rather than having two "square" or "rectangular" shaped locating pins that are spaced closer together than the holes in the substrate, one locating pin can be square or rectangular and one can be triangular.

In an example, a third locating pin of the plurality of locating pins projects from the coil element in the direction parallel to the pin axis. Prior to the coil element being mounted to the substrate a cross section of the third locating pin perpendicular to the pin axis comprises fourth and fifth inner vertices facing toward the first locating pin, and the first and second and fourth and fifth inner vertices form (or define) a first quadrangle. When the coil element is mounted to the first surface of the substrate the third locating pin is located in a third hole of the plurality of holes such that the fourth and fifth inner vertices are in contact with fourth and fifth regions on the inside of the third hole. Prior to the coil element being mounted to the substrate fourth and fifth circumferential points of the third circular cross section hole correlate with the fourth and fifth regions, wherein the first and second and fourth and fifth circumferential points form (or define) a second quadrangle larger than the first quadrangle.

In an example, the first and second quadrangles are trapezoids.

In an example, the first and second quadrangles are rectangles.

In an example, a third locating pin of the plurality of locating pins projects from the coil element in the direction parallel to the pin axis. Prior to the coil element being mounted to the substrate a cross section of the third locating pin perpendicular to the pin axis comprises a fourth inner vertex facing toward the first locating pin, and the first and second and fourth inner vertices form (or define) a third triangle. When the coil element is mounted to the first surface of the substrate the third locating pin is located in a third hole of the plurality of holes such that the fourth inner vertex is in contact with a fourth region on the inside of the third hole. Prior to the coil element being mounted to the substrate a fourth circumferential point of the third circular cross section hole correlates with the fourth region, and the first and second and fourth circumferential points form (or define) a fourth triangle larger than the third quadrangle.

In an example, the substrate is a printed circuit board (PCB).

In an example, the coil element comprises two flanges 50 located at either end of the winding body, and when the coil element is mounted to the first surface of the substrate at least a portion 110 of each of the two flanges is in contact with the first surface of the substrate.

In this way a predetermined distance of the winding body and wire with respect to the substrate can be ensured.

In an example, each flange is arranged perpendicular to the axis of the winding body.

In an example, each flange comprises two supporting edges 110 at opposite ends of one side of the flange, and when the coil element is mounted to the first surface of the substrate the two supporting edges of each flange are in contact with the first surface of the substrate.

In this way, the supporting edges support the coil element on the substrate and ensure a predetermined spacing between the winding body, upon which the wire has been wound, the wound wire can also be termed a winding segment, and the substrate. Thus, the coil element can be accurately positioned vertically with respect to the substrate, improving consistency of signals, and where a series of coil elements are mounted on the substrate, in for example a Rogowski coil configuration, the signal from each coil element will be consistent with the signals from the other coil elements. This improves accuracy of the current sensing device and improves reproducibility of signals between current sensing devices, such that a sensing device can be replaced with a different sensing device and will provide signals consistent with the previous sensing device, and reference or calibration data sets can be applied to all the sensing devices and each sensing device does not need to have its own reference data set or calibration data set. Thus, different devices can be utilized to diagnose situations, based on signal detection, that that particular device has not been calibrated to diagnose, but can use data acquired by a different device.

In an example, the first locating pin of the plurality of locating pins is connected to or part of a first flange of the two flanges, and the second locating pin of the plurality of locating pins is connected to or part of a second flange of the two flanges.

Thus, economic and reproducible manufacturability is provided.

In an example, the third locating pin is connected to or part of the second flange.

In an example, the first flange comprises at least one recessed portion 120 adjacent to the first locating pin, and the second flange comprises at least one recessed portion 120 adjacent to the second locating pin, and a surface of the flange within the recessed portion of each flange facing the first surface of the substrate is spaced from the first surface of the substrate.

The recess enables a locating pin to bend and/or deform more than it could if there was no recess. This addresses the issues of manufacturing errors or tolerances, providing for reliable and economic manufacturability.

In an example, the current sensing device further comprises a second substrate. The second substrate comprises a one or more holes projecting at least part way through the second substrate from a first surface of the second substrate. Prior to the coil element being mounted to the second substrate each of the one or more holes has a circular cross section. One or more further locating pins of the plurality of locating pins project from the coil element in the direction parallel to the pin axis. When the coil element is mounted to the first surface of the substrate and mounted to the first surface of the second substrate the first surface of the substrate faces the first surface of the second substrate and the coil element is located between the substrate and the second substrate and the one or more further locating pins are located in the one or more holes of the second substrate.

Using a second substrate, such as a PCB, provides further improved stability and precision for the positioning of the coil element or elements.

In an example, a first locating pin of the one or more further locating pins is connected to or part of the first flange.

In an example, the one or more circular cross section holes of the second substrate are a plurality of circular cross section holes, and the one or more further locating pins are a plurality of further locating pins, and a second locating pin of the one or more further locating pins is connected to or part of the second flange.

In an example, when the coil element is mounted to the first surface of the substrate the first locating pin and the second locating pin have deformed the first cross section hole and the second cross section hole in the substrate.

In an example, when the coil element is mounted to the first surface of the substrate the inner vertices of the first locating pin and the second locating pin have been deformed by the first cross section hole and the second cross section hole in the substrate.

In an example, the current sensing device comprises a plurality of coil elements mounted to the substrate.

Each of the coil elements can be configured as described above with respect to the above described coil element and mounted to the substrate as described above for the coil element.

In an example, the current sensing device is configured as a Rogowski coil.

From the above description of this current sensing device, in its different possible examples, a clear teaching is provided regarding a method of manufacturing such a current sensing device, in its different examples.

In an example, a current sensing device comprises a substrate 40, and one or more coil elements 30. The substrate comprises a plurality of holes 100 projecting at least part way through the substrate from a first surface of the substrate, and prior to a coil element being mounted to the substrate each of the plurality holes has a circular cross section. The holes can go all the way through the substrate. The coil element comprises a winding body 10, 20, a length of wire 80, and a plurality of locating pins 60. The winding body has an outer surface around an axis of the winding body, and at least a portion of the length of wire is wound multiple times around the outer surface of the winding body in a generally circumferential direction with respect to the axis of the winding body. The wound wire can be termed a winding segment. A first locating pin of the plurality of locating pins projects from the coil element in a direction parallel to a pin axis that is perpendicular to the axis of the winding body, and a second locating pin of the plurality of locating pins projects from the coil element in the direction parallel to the pin axis. Prior to the coil element being mounted to the substrate a cross section of the first locating pin perpendicular to the pin axis comprises a first inner vertex facing toward the second locating pin, and a cross section of the second locating pin perpendicular to the pin axis comprises a second inner vertex facing toward the first locating pin, and the two inner vertices form (or define) a first line. When the coil element is mounted to the first surface of the substrate the first locating pin is located in a first hole of the plurality of holes such that the first inner vertex is in contact with a first region on the inside of the first hole and the second locating pin is located in a second hole of the plurality of holes such that the second inner vertex is in contact with a second region on the inside of the second hole. Prior to the coil element being mounted to the substrate, a first circumferential point of the first circular cross section hole correlates with the first region, and a second circumferential point of the second circular cross section hole correlates with the second region, and the two circumferential points form (or define) a second line longer than the first line.

In other words, before the coil element is inserted into the substrate a distance between inner extents of the two location pins are spaced apart by a distance smaller than the minimum separation of the inner circumferences of the two holes in the substrate,

Thus, rather than having two "square" or "rectangular" shaped locating pins that are spaced further apart than the holed in the substrate, of having one of those two locating pins in a triangular form, both could be triangular with an apex pointing outwards and only the apex of both triangles engaging with the holes in the substrate.

In an example, a third locating pin of the plurality of locating pins projects from the coil element in the direction parallel to the pin axis. Prior to the coil element being mounted to the substrate a cross section of the third locating pin perpendicular to the pin axis comprises third and fourth inner vertices facing toward the first locating pin, and the first and third and fourth inner vertices form (or define) a first triangle. When the coil element is mounted to the first surface of the substrate the third locating pin is located in a third hole of the plurality of holes such that the third and fourth inner vertices are in contact with third and fourth regions on the inside of the third hole. Prior to the coil element being mounted to the substrate third and fourth circumferential points of the third circular cross section hole correlate with the third and fourth regions, and the first and third and fourth circumferential points form (or define) a second triangle larger than the first triangle.

In an example, a third locating pin of the plurality of locating pins projects from the coil element in the direction parallel to the pin axis. Prior to the coil element being mounted to the substrate a cross section of the third locating pin perpendicular to the pin axis comprises a third inner vertex facing toward the first locating pin, and the first and third inner vertices form (or define) a third line. When the coil element is mounted to the first surface of the substrate the third locating pin is located in a third hole of the plurality of holes such that the third inner vertex is in contact with a third region on the inside of the third hole. Prior to the coil element being mounted to the substrate a third circumferential point of the third circular cross section hole correlates with the third region, and the first and third circumferential points form (or define) a fourth line longer than the third line.

In an example, the substrate is a printed circuit board (PCB).

In an example, the coil element comprises two flanges 50 located at either end of the winding body, and when the coil element is mounted to the first surface of the substrate at least a portion 110 of each of the two flanges is in contact with the first surface of the substrate.

In this way a predetermined distance of the winding body and wire with respect to the substrate can be ensured.

In an example, each flange is arranged perpendicular to the axis of the winding body.

In an example, each flange comprises two supporting edges 110 at opposite ends of one side of the flange, and when the coil element is mounted to the first surface of the substrate the two supporting edges of each flange are in contact with the first surface of the substrate.

In this way, the supporting edges support the coil element on the substrate and ensure a predetermined spacing between the winding body, upon which the wire has been wound, the wound wire can also be termed a winding segment, and the substrate. Thus, the coil element can be accurately positioned vertically with respect to the substrate, improving consistency of signals, and where a series of coil elements are mounted on the substrate, in for example a Rogowski coil configuration, the signal from each coil element will be consistent with the signals from the other coil elements. This improves accuracy of the current sensing device and improves reproducibility of signals between current sensing devices, such that a sensing device can be replaced with a different sensing device and will provide signals consistent with the previous sensing device, and reference or calibration data sets can be applied to all the sensing devices and each sensing device does not need to have its own reference data set or calibration data set. Thus, different devices can be utilized to diagnose situations, based on signal detection, that that particular device has not been calibrated to diagnose, but can use data acquired by a different device.

In an example, the first locating pin of the plurality of locating pins is connected to or part of a first flange of the two flanges, and the second locating pin of the plurality of locating pins is connected to or part of a second flange of the two flanges.

Thus, economic and reproducible manufacturability is provided.

In an example, the third locating pin is connected to or part of the second flange.

In an example, the first flange comprises at least one recessed portion 120 adjacent to the first locating pin, and the second flange comprises at least one recessed portion 120 adjacent to the second locating pin, and a surface of the flange within the recessed portion of each flange facing the first surface of the substrate is spaced from the first surface of the substrate.

The recess enables a locating pin to bend and/or deform more than it could if there was no recess. This addresses the issues of manufacturing errors or tolerances, providing for reliable and economic manufacturability.

In an example, comprising a second substrate, and the second substrate comprises a one or more holes projecting at least part way through the second substrate from a first surface of the second substrate. Prior to the coil element being mounted to the second substrate each of the one or more holes has a circular cross section. One or more further locating pins of the plurality of locating pins project from the coil element in the direction parallel to the pin axis. When the coil element is mounted to the first surface of the substrate and mounted to the first surface of the second substrate the first surface of the substrate faces the first surface of the second substrate and the coil element is located between the substrate and the second substrate and the one or more further locating pins are located in the one or more holes of the second substrate.

Using a second substrate, such as a PCB, provides further improved stability and precision for the positioning of the coil element or elements.

In an example, a first locating pin of the one or more further locating pins is connected to or part of the first flange.

In an example, the one or more circular cross section holes of the second substrate are a plurality of circular cross section holes, and the one or more further locating pins are a plurality of further locating pins, and a second locating pin of the one or more further locating pins is connected to or part of the second flange.

In an example, when the coil element is mounted to the first surface of the substrate the first locating pin and the second locating pin have deformed the first cross section hole and the second cross section hole in the substrate.

In an example, when the coil element is mounted to the first surface of the substrate the inner vertices of the first locating pin and the second locating pin have been deformed by the first cross section hole and the second cross section hole in the substrate.

In an example, the current sensing device comprises a plurality of coil elements mounted to the substrate.

Each of the coil elements can be configured as described above with respect to the above described coil element and mounted to the substrate as described above for the coil element.

In an example, the current sensing device is configured as a Rogowski coil.

From the above description of this current sensing device, in its different possible examples, a clear teaching is provided regarding a method of manufacturing such a current sensing device, in its different examples.

Thus the inventors realized that the accuracy of the measurement voltage depends on the position accuracy of each winding segment and they developed a new way to mount the coil elements to a substrate in precise positions.

Thus, current sensing devices with high measuring accuracy and low cost can be provided for many electrical applications. The improved arrangements, where precise position of the coil elements is ensured, has a low manufacturing cost.

Thus, the new developments allow manufacturing a current sensing device with compact size, high accuracy, high stability, high productivity, and low manufacturing cost.

High measurement accuracy is ensured by the precise position of the coil elements around the conductor carrying the current to be measured. This is achieved by precisely positioning the coil elements on a substrate using locating pins and retaining holes. The locating pins and the retaining holes are configured to optimize the positioning accuracy of a coil element with respect to the substrate and to allow for small deformations to occur during engagement. The positioning accuracy of a coil element is ensured by touch surfaces between locating pins and walls of retaining holes and by distributing the touch surfaces to lock the coil element in any direction in the plane of the substrate.

Good positioning stability in the plane of the substrate is ensured by providing the touch surfaces close to extremities of the coil element.

Good positioning stability of a coil element in a direction perpendicular to the plane of the substrate is achieved by the retaining force between inner walls of retaining holes and locating pins of a coil element.

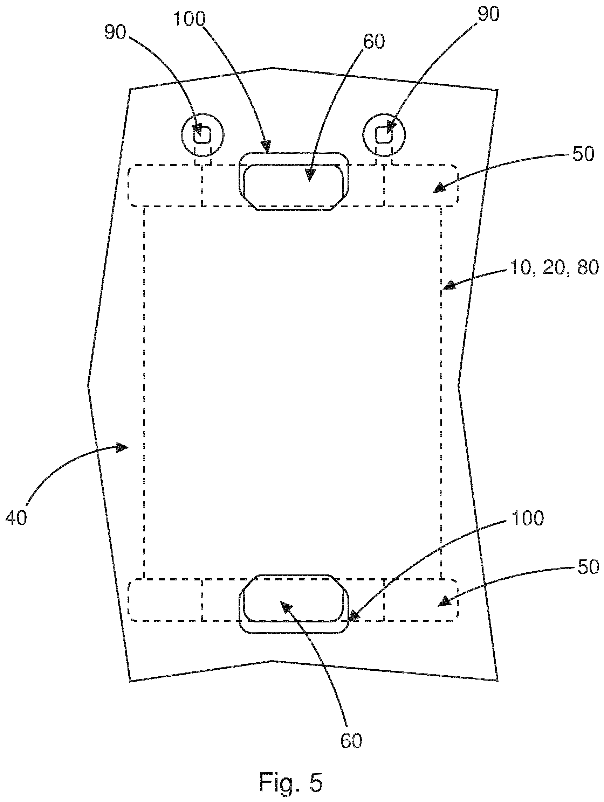

The positioning accuracy and the cost are optimized by reducing the impact of manufacturing tolerances on positioning accuracy. This is achieved by enabling deformations of the locating pins and/or of the retaining holes. Deformations are facilitated by the sharp positioning edges where material can be locally removed or displaced relatively easy in the narrow touch surfaces upon engagement of the locating pins of a coil element in respective retaining holes of the substrate. For example, a sharp positioning edge may get a portion removed during the engagement or a sharp positioning edge may cut a dint in a wall of a retaining hole. The sharp positioning edge is configured to cause a localized deformation of the locating pin, or of the retaining hole, or of both, whilst the coil element is attached to the substrate. A localized deformation can appear like a discontinuity along the sharp positioning edge of the locating pin or on the inner wall of the hole, e.g. being comprised between 0.02 mm and 0.15 mm. A predetermined discontinuity, for example like a step, or a chamfrain, or a taper, can be deliberately provided on an edge of the pin comprising the sharp positioning edge to conceal the localized deformation. A sharp positioning edge may have a rounding, which is less than the rounding of the hole in the contact region. A solution with a sharp positioning edge having a rounding with a radius of 0.3mm has been successfully implemented by the inventors, represented here in Fig. 5. Deformations are also facilitated by bending of the locating pins. A hollow region to separate the lateral sides of the locating pin from the coil element is provided to extend the length of a bendable portion of the locating pin. The hollow region may comprise one recess in a flange, e.g. if the locating pin is at the edge of the flange, or two recesses in a flange, e.g. if the locating pin is in the middle of the flange. The depth of the recess(es) is a practical design parameter to control the bending behavior of the locating pin. A portion of the locating pin with reduced cross section can be provided to increase the ability to bend of the locating pin. A predetermined curved portion of the pin can be deliberately provided to extend the length of a bendable portion of the locating pin. A bend of the locating pin can be characterized by an angular deviation preferably comprised between 0.2 degrees and 15 degrees.

The positioning accuracy and stability in a direction perpendicular to the plane of a substrate is further improved by providing a second substrate to lock the coil elements between the substrates.

The positioning accuracy and stability in the plane of a substrate is further improved by providing the coil elements and the second substrate with respective locating pins and retaining holes.

The retaining holes can be of various shape like circular, oval, trapezoid, polygonal with rounded corners, or combinations of the above. They can be produced for example by milling, punching, or laser cutting, with an example shown in Fig. 5 having retaining holes with a shape comprising a polygon (for example a combination of a rectangle and a trapezoid) with rounded corners that was successfully implemented by the inventors. Retaining holes with round shape can be produced with high precision and low cost in practically any type of substrate, e.g. using drilling or punching. However, as discussed above non circular shaped holes can be produced.

Production of linear coil elements and assembly of the coil elements on PCB substrates are suitable for high productivity and low cost, for example by using proven automated techniques.

Low cost is achieved by providing a relatively simple PCB substrate with multiple functionalities: mechanical support, accurate positioning, electrical connectivity, electrical shielding, etc.

The locating pins are efficiently integrated into the coil element and the coil elements can be arranged densely which is beneficial for reaching high accuracy and compact size of the device. Compact size of the device is also achieved by a substrate which is preferably planar and thin.

The coil elements are distributed in a polygonal closed path. They can be uniformly distributed to form a regular polygon. Practical cost and accuracy tradeoffs are achieved using preferably between 6 and 32 coil elements. However, any number of coil elements equal or greater than 2 can be employed. In the case of larger devices, the substrate may comprise multiple substrate segments.

The current sensing devices and methods of manufacturing current sensing devices are described in further detail with respect to specific embodiments.

Fig. 1 shows a current sensing device 1 with 12 coil elements 30 mounted on a substrate 40, such as a PCB, and being uniformly distributed in a closed path around an opening provided in the substrate for a conductor carrying a current to be sensed. A coil element 30 comprises a winding segment with a plurality of turns of wire 80 applied on a winding body 10, 20 of a bobbin.

Each coil element 30 has locating pins 60 and the PCB 40 has mating retaining holes that are configured to precisely position the coil element to the PCB and to hold the coil element to the PCB with a retaining force. The locating pins 60 are shown in the figures. The locating pins can be just one side, for example a bottom of the coil element 30, but can also be at the top and bottom of the coil element. In the arrangement with locating pins at one side of the coil element only one PCB 40 is used. In the arrangement with locating pins at the top and bottom, there are actually two PCBs 40 used for a current sensing device. The coil elements 30 connect to a lower PCB 40 via locating pins 60 at the bottom of the coil element 30 and the coil elements 30 connect to an upper PCB 40 via a second one of the locating pins 60 at the top of the coil element. Thus, looking at Fig. 1 there can be just one annular shaped PCB 40 with coil elements 30 mounted to it or there can be two parallel and annular shaped PCBs 40 with coil elements 30 between them. The two PCBs 40 can be locked together with locking means, for example using locking pins. It is to be noted that an upper PCB substrate is optional. Using only a lower PCB substrate is a basic arrangement, which is sufficient in many applications, where coil elements with or without locating pins at the top can be employed. In this case, it is possible to use coil elements with locating pins at the top without inserting them in a substrate. The same coil element can be reused in alternative implementations of a device using a lower PCB substrate and an upper PCB substrate. Or a different type of substrate, or a housing or a part of a housing of the device can be employed instead of the upper PCB substrate. The substrate or the PCB substrate can be of any shape as required, for example annular or polygonal or a more complex geometry.

The winding body 10, 20 can be of any shape as required. For example, a winding body 10 can be generally rectangular in cross section, with rounded corners and with two opposing sides have flat sections and the other two opposing sides have no flat sections and being curved to a certain extent. For example, a winding body 20 can be generally rectangular in cross section, with rounded corners and with two opposing sides having no flat sections and being curved to a certain extent, and the other two opposing sides have no flat sections and being curved to a certain extent.

Thus, continuing with Fig. 1 this shows a current sensing device 1 with 12 coil elements 30 mounted on a substrate 40 and being uniformly distributed in a closed path around an opening provided in the substrate for a conductor carrying a current to be sensed. Practical cost and accuracy tradeoffs are achieved using preferably between 6 and 32 coil elements 30. A coil element 30 comprises a winding segment applied on a winding body 10, 20 of a bobbin, where two flanges 50 delimit the winding segment, and there are two connecting pins 90 to connect to both ends of the wire 80. The substrate 40 is preferably a PCB provided with an electrically shielding plane like a ground plane at least on the side opposite to the coil elements 30 and with traces for sensing signals mainly on the side facing the coil elements 30. Each coil element is provided with locating pins 60 and the PCB substrate comprises mating retaining holes.

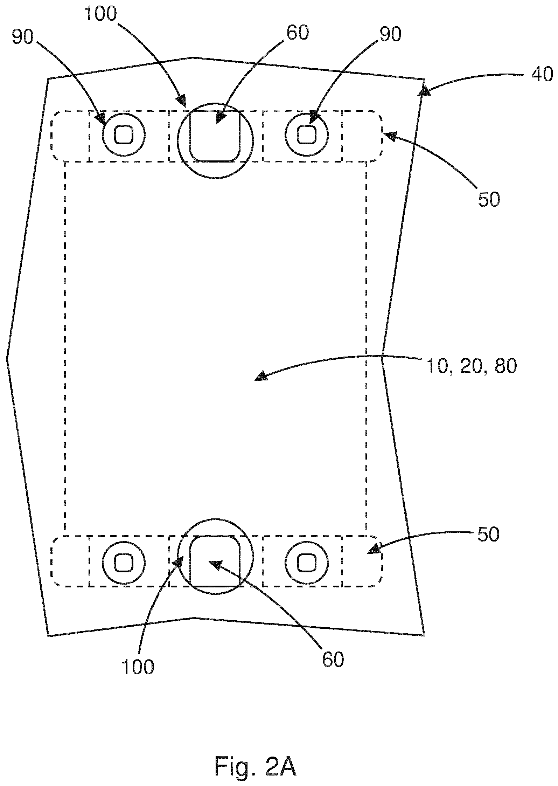

Fig. 2A shows a portion of a substrate from the opposite side where a coil element is mounted. Thus, looking at Fig 2A the viewer could be looking at the underside of the current sensing device 1 of Fig. 1, where a coil element 30 is on the other side of the substrate 40 that is being looked at. Mounting is achieved by engaging two locating pins 60 of a coil element 30 into two respective retaining holes 100 of the substrate 40. The substrate is flat and the retaining holes have a round shape which is suitable for low cost and precise manufacturing. They are slightly larger than the locating pins, having a diameter typically comprised between 0.5 mm and 5 mm, preferably between 0.7mm and 2.5 mm. A locating pin 60 is provided on each flange 50 of the winding body 10, 20 of the coil element and each locating pin 60 has two sharp positioning edges in touch with the inner wall of the retaining hole, forming two respective narrow touch surfaces. The width of a narrow touch surface is less than one tenth of the circumference of the hole. A total of four narrow touch surfaces are provided where two narrow touch surfaces at one side of the coil element have approximately orthogonal directions. two narrow touch surfaces placed diagonally over the coil element have approximately opposite directions. The narrow touch surfaces are configured to block the coil element in any direction in the plane of the substrate. Connecting pins 90, for connecting to the wire 80 wound round the winding body 10, 20 of the coil element 30, are shown either side of a locating pin 60.

In the example from Fig. 2A, the sharp positioning edges partly take the shape of the retaining holes near the narrow touch surfaces. In a state prior to mounting, the coil element and the substrate are configured to provide a small overlap between the sharp positioning edges and the inner walls of the retaining holes. Mounting the coil element to the substrate causes pressing forces from inner walls of the retaining holes on the locating pins and small deformations of the engaged parts. Sharp positioning edges and narrow touch surfaces allow for deformations caused by material getting displaced or removed during engagement to happen relatively easy. They enable more intimate contact between the engaged parts and improve the positioning stability of the coil element. The pressing forces from inner walls of retaining holes on locating pins provide a retaining force, e.g. through friction, to hold the coil element to the substrate. Providing the narrow touch surfaces at the outer side of the flange result in a total pressing force on the flange towards the center of the coil element causing compressive stress on the bobbin which is easier to withstand than tear stress.

The coil element comprises 2 connecting pins 90 to which the ends of the winding wire 80 in the winding segment are contacted. The connecting pins are provided at the same flange of the coil element, at each lateral side of a locating pin. The substrate is preferably a PCB having connecting holes sufficiently large to receive the connecting pins without subjecting them to mechanical stress. The PCB is provided with an electrically shielding plane like a ground plane at least on the side opposite to the coil elements and with traces for sensing signals mainly on the side facing the coil elements.

Thus, looking at Fig. 2A at the lower hole 100 the locating pin 60 has two deformed vertices that have been deformed as they were pushed into the circular hole. And at the upper hole 100 the locating pin has two deformed vertices that have been deformed as the locating pin was pushed into the circular hole. Before being deformed each of the vertices overlapped the hole into which it would be pushed, thus the two vertices at the bottom hole 100 of the locating pin were further from the centre of the circular hole 100 than a radius of the hole, and the vertices at the top hole 100 of the locating pin were further from the centre of the circular hole 100 than a radius of the hole. These four vertices of the two locating pins 60 before they were pushed into their respective holes form or define a first quadrangle that is in effect a rectangle. Then after the locating pins were pushed into their respective holes, each of the four contact regions on the inside of the circular cross section holes have a centre point and these four centre points form or define a second quadrangle that is smaller than the first quadrangle. However, rather than the locating pins 60 deforming as they are pushed into the holes, they can maintain their shape edges and cut into and deform the circular holes. Again the four apexes define the first quadrangle, and where the circular cross sections have been deformed, the centre of the four regions for the un-deformed circles again defines the second quadrangle smaller than the first quadrangle.

Also, rather than have the locating pins 60 in effect spaced slightly too far apart for the holes into which they are to be pushed, and therefore are deformed or deform the substrate, the locating pins can be space apart not far enough for the holes into which they are to be pushed. Thus now, looking at Fig. 2A the locating pins 60 engage with inner facing parts of the holes 100 in the substrate rather than the out facing parts of the holes.

In this situation, the quadrangle formed by the four apexes of two locating pins before being pushed into their respective holes is smaller than the quadrangle formed from the four regions of the circular cross section holes that the four apexes will engage with (and either be deformed and leave the holes as circular cross sections, or cut into and deform the circular cross section holes).

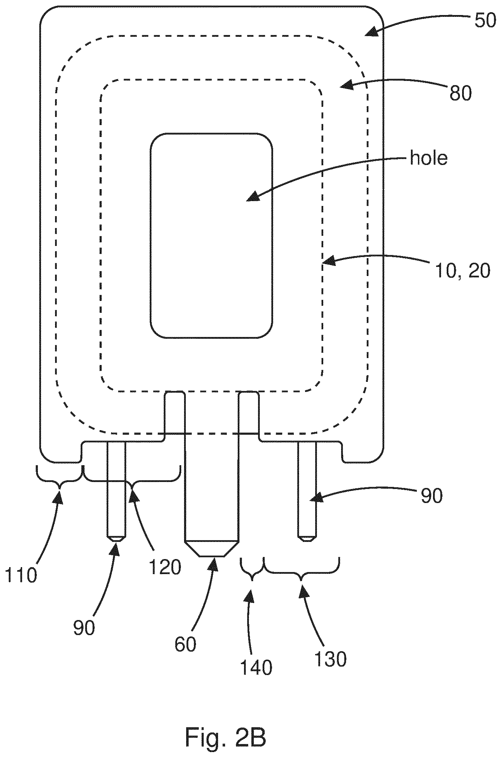

Fig. 2B shows a view from the outer side of a flange50 of a coil element 30. The winding body 10, 20 and the winding segment with its wire 80 are indicated by dashed lines, and a hole extended through the body of the winding body 10, 20, and where the substrate 40 has been removed. The coil element has 110 supporting edges at the bottom lateral sides of the flange and a locating pin 60 approximately in the middle of the flange 50. If the substrate 40 was present the locating pin 60 would be located in a hole 100 in the substrate and the two supporting edges 110 would be touching a first surface of the substrate. The supporting edges 100 are configured to support the coil element 30 on the substrate 40 and to ensure a predetermined spacing between the winding segment (the wire 80 around the winding body 10, 20) and the substrate 40. A recess 120 is provided between each supporting edge 110 and the locating pin 60. The recess 120 has two steps 130 and 140, and the deeper step 140 preferably reaches the winding body 10, 20 of the bobbin as shown in Fig. 2B. The recesses provide additional deformation capability to the locating pin, allowing it to slightly bend in a region between the winding body and the substrate. There need not be two recesses, and just one recess that spaces the flange 50 from the substrate 40 between the locating pin 60 and the supporting edge 110 is sufficient. The capability of the locating pin 60 to bend during engagement allows to better control the pressing forces from inner walls of the retaining hole 100 on the locating pin 60 in the presence of manufacturing errors or tolerances. Improved reliability and economical manufacturing is thus achieved.

Rather than reaching the winding body, the recess 120 can have a deep portion that is preferably larger than 25% of the spacing between the supporting edge and the winding body, and an improved outcome is generally achieved when the recess is larger than 50% of the spacing between the supporting edge and the winding body, and as described above it can be preferable to have the recess going all the way to the winding body 10, 20.

In Fig. 2A and 2B, a locating pin 60 is a protrusion from a flange 50 being made of a same material. The locating pins 60 are sturdier than the connecting pins 90 to ensure good stability of the coil element and of its mounting.

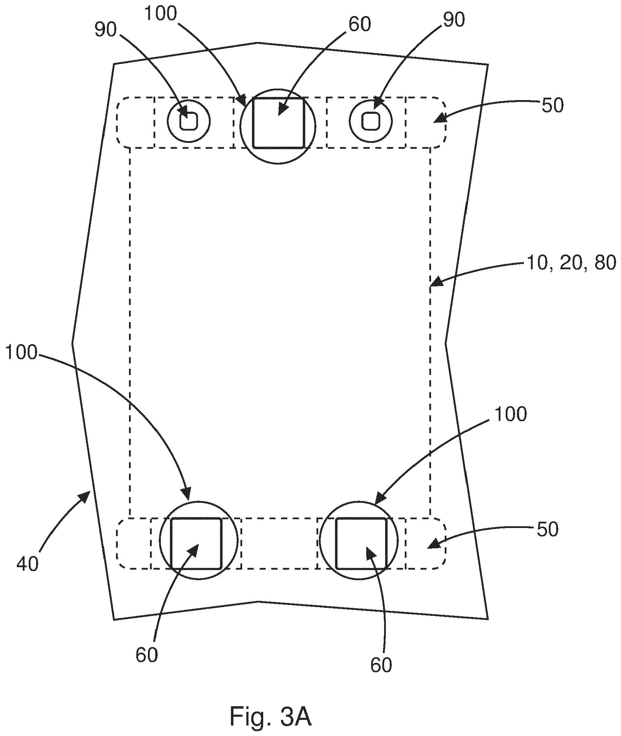

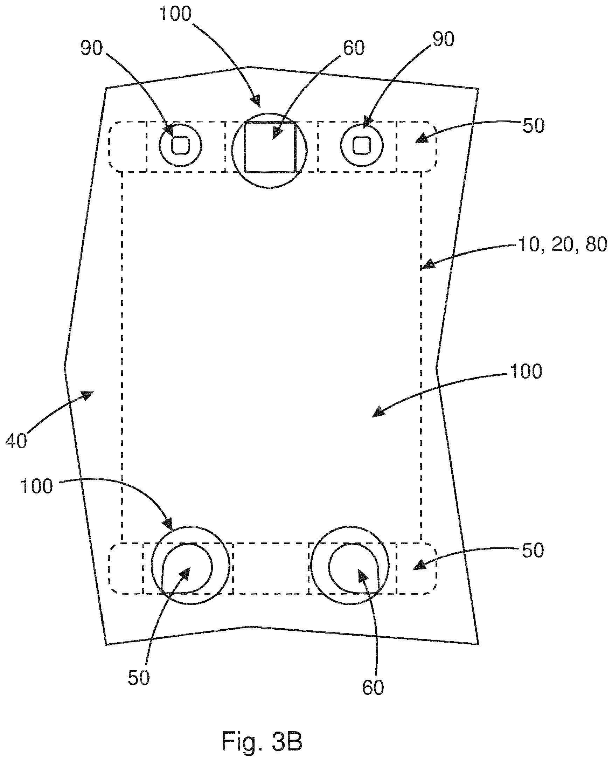

Fig. 3 shows an alternative arrangement of locating pins 60 and retaining holes 100, where now there are three locating pins 60 located in holes 100 of the substrate.

Thus, looking at Fig. 3A at the upper hole 100 the locating pin 60 has two deformed vertices that have been deformed as they were pushed into the circular hole. And at the lower right hole 100 the locating pin has two deformed vertices that have been deformed as the locating pin was pushed into the circular hole. And at the lower left hole 100 the locating pin has two deformed vertices that have been deformed as the locating pin was pushed into the circular hole. In Fig. 3A, the two pins from the lower longitudinal end of the coil can each have each only one outer vertex in contact with the inside of the hole. Thus, only one outer vertex can have a functional role, and the remaining cross-section of the pin can be arbitrarily shaped, with Fig. 3B showing an example. Before being deformed each of the vertices overlapped the hole into which it would be pushed, thus the two vertices at the top hole 100 of the locating pin were further from the centre of the circular hole 100 than a radius of the hole, and the vertices at the bottom right hole 100 of the locating pin were further from the centre of the circular hole 100 than a radius of the hole. These four vertices of the two locating pins 60 before they were pushed into their respective holes form or define a first quadrangle in the form of a trapezoid. Then after the locating pins were pushed into their respective holes, each of the four contact regions on the inside of the circular cross section holes have a centre point and these four centre points form or define a second quadrangle in the form of a trapezoid that is smaller than the first trapezoid. However, rather than the locating pins 60 deforming as they are pushed into the holes, they can maintain their shape edges and cut into and deform the circular holes. Again the four apexes define the first trapezoid, and where the circular cross sections have been deformed, the centre of the four regions for the un-deformed circles again defines the second trapezoid smaller than the first trapezoid. As made clear above, there can be three contact regions. Implementing more than three contact regions needs more attention in dealing with tolerances and the challenge increases with the number of contact regions. However, employing four contact regions provides a good tradeoff between dealing with tolerances, achieving good stability, and a practical design, but fewer than four can be utilized. Employing more than four contact regions is possible.

Also, rather than have the locating pins 60 in effect spaced slightly too far apart for the holes into which they are to be pushed, and therefore are deformed or deform the substrate, the locating pins can be space apart not far enough for the holes into which they are to be pushed. Thus now, looking at Fig. 3A the locating pins 60 engage with inner facing parts of the holes 100 in the substrate rather than the outer facing parts of the holes.

In this situation, the trapezoid formed by the four apexes of two locating pins before being pushed into their respective holes is smaller than the trapezoid formed from the four regions of the circular cross section holes that the four apexes will engage with (and either be deformed and leave the holes as circular cross sections, or cut into and deform the circular cross section holes).

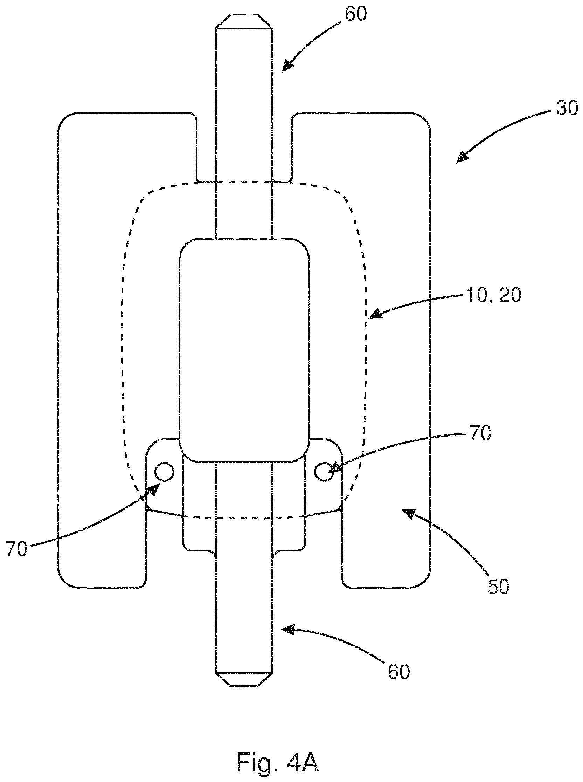

Fig. 4A shows a coil element 30 from a view from the outer side of a flange 50 of a bobbin having a winding body 10, 20 where the flange 40 is provided with locating pins 60 at the bottom and at the top. Thus, one PCB 40 is below coil element 30 and one PCB 40 is above the coil element 30 and the two locating pins 60 are located into the PCB. The bobbin has a winding body 10, 20 with a winding contour as shown as a dashed line. Thus, into the page of Fig, 4A an axis runs down the centre of the winding body 10, 20 and in Fig, 3A this axis is locally in a circumferential direction of the annular part of the current sensing device 1. The winding body 10, 20 comprises two holes for inserting two respective connecting pins from the outer side of the flange for connecting to the wire 80. After connecting the ends of the winding wire 80 to the connecting pins, the connecting pins are curved in a direction to reach the PCB substrate, the direction being similar to that of the adjacent locating pin 60. The curved segment is configured to reduce the tension in the end of the winding wire 80 and to provide damping between the end of the winding wire 80 and a segment of the connecting pin connected to the PCB 40. A guiding channel like a groove is provided in the flange for a portion of the segment of a connecting pin connected to the PCB substrate.

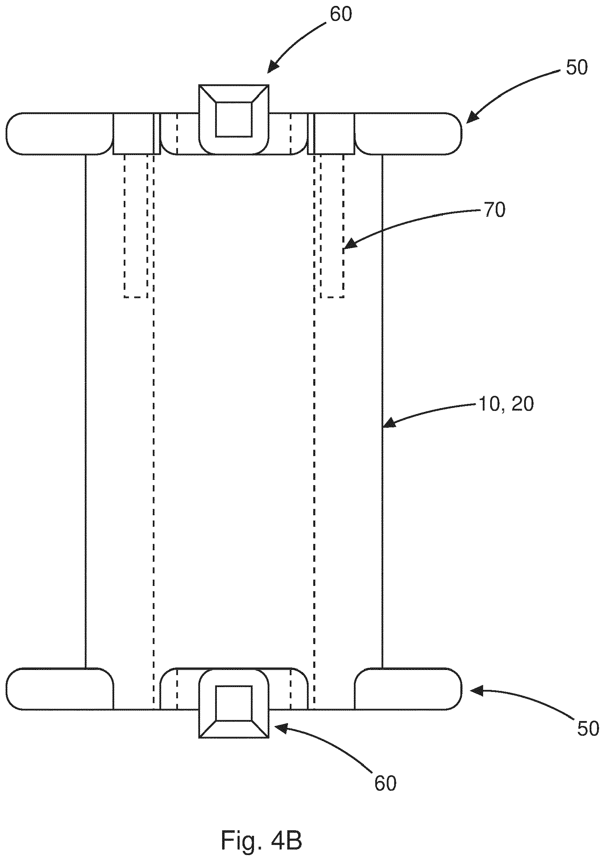

Fig 4B shows a view of coil element 30 with the bobbin and winding body 10, 20 in plan view, and actually shown from the bottom side and thus is a view from the bottom of the coil element 30 as shown in Fig, 4A. The thickness of a flange 50 is small at the lateral sides, and it is larger at the locating pin 60. Minimizing the thickness of flanges at least at the side facing the conductor allows maximizing the space occupied by the winding segments of the coil elements and thus improving the sensitivity and accuracy of the current sensing device.

The coil element 30 with the bobbin having a winding body 10, 20 from Fig. 4A and Fig 4B can be used in a current sensing device 1 where the coil elements 30 are clamped between two PCBs 40 and the coil elements 30 are provided with locating pins 60 engaged in retaining holes in both substrates. Using a second PCB 40 provides further improved stability and precision for the position of the coil elements 30. Holding pins with locking anchors are preferably provided to lock the two PCBs in a firm position. A locking anchor can be a head of the holding pin, or an enlarged portion of the holding pin, or a deformation of the holding pin, or a soldered locking anchor, or a combination of the above, or other practical implementation. The holding pins are preferably electrical pins compatible with common PCB assembly methods such as wave soldering. They can connect electrical signals between the PCBs, in particular an electrical shield potential provided on shielding planes of the PCBs.

A first PCB 40 comprises electrical connections for the coil elements 30 and connectivity means for interfacing the device to external apparatus. The second PCB 40 has a construction preferably identical to the first PCB, such that they are manufacturable in a same batch to result in simple and cheap production. The main differences between the two PCBs would be related to the electrical connections being assembled. However, as discussed above the coil elements 30 can be connected to a substrate 40 from one end only, and there need only be one substrate 40, such as a PCB.

The first (or only) PCB 40 can have a setting resistor connected in parallel with the assembly of coil elements 30 to shunt the output of the current sensing device 1. Its resistance value is dimensioned according to the resistance of the coil elements 30 and to the temperature coefficient of the winding wire 80 of the coil elements to achieve a desired temperature coefficient of the measurement voltage of the current sensing device.

The following figures provide details on various shapes of locating pins 60 and of holes 100 in the substrate.
Fig. 5 shows a view of an exemplar current sensing device viewing a second surface of a substrate and where a coil element is mounted to a first surface of the substrate facing away from the viewer, where a locating pin has rounded sharp positioning edges, and retaining holes in the substrate have a polygonal shape;

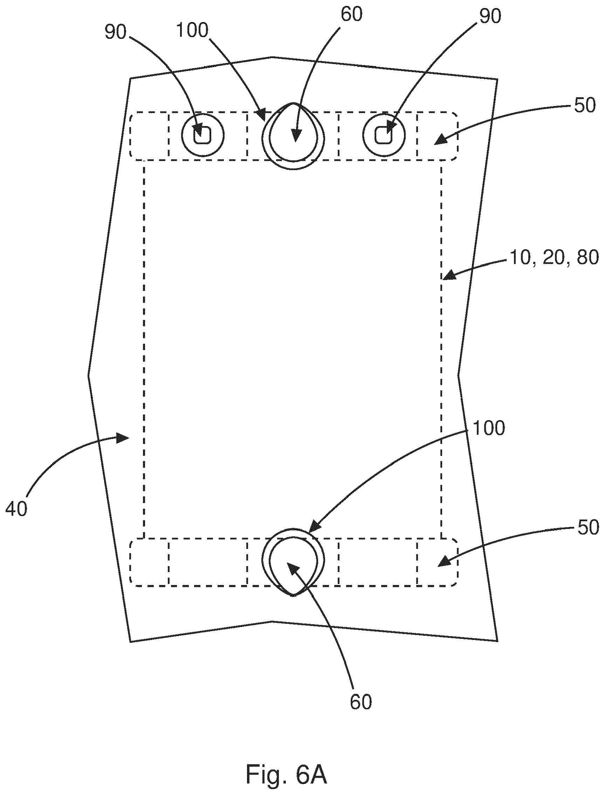

Fig. 6A shows a view of an exemplar current sensing device viewing a second surface of a substrate and where a coil element is mounted to a first surface of the substrate facing away from the viewer, with shaped locating pins;

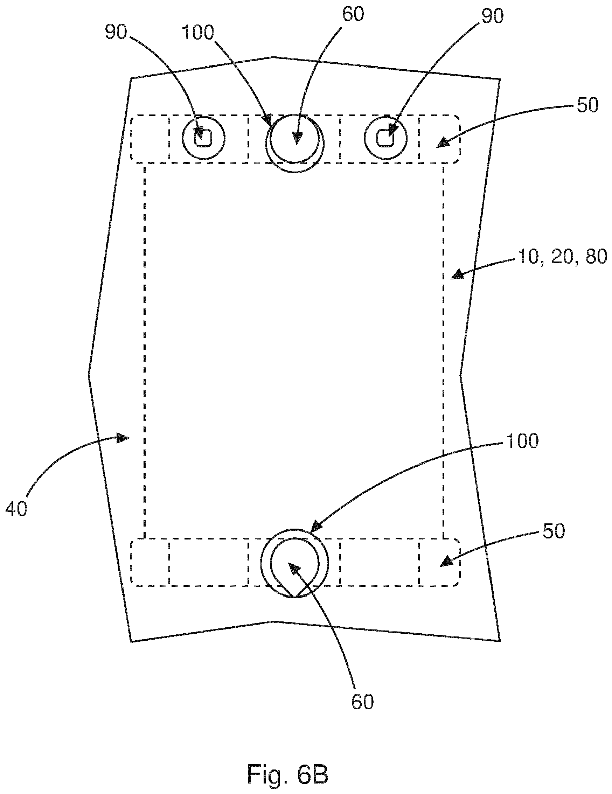

Fig. 6B shows a view of an exemplar current sensing device viewing a second surface of a substrate and where a coil element is mounted to a first surface of the substrate facing away from the viewer, with shaped locating pins;

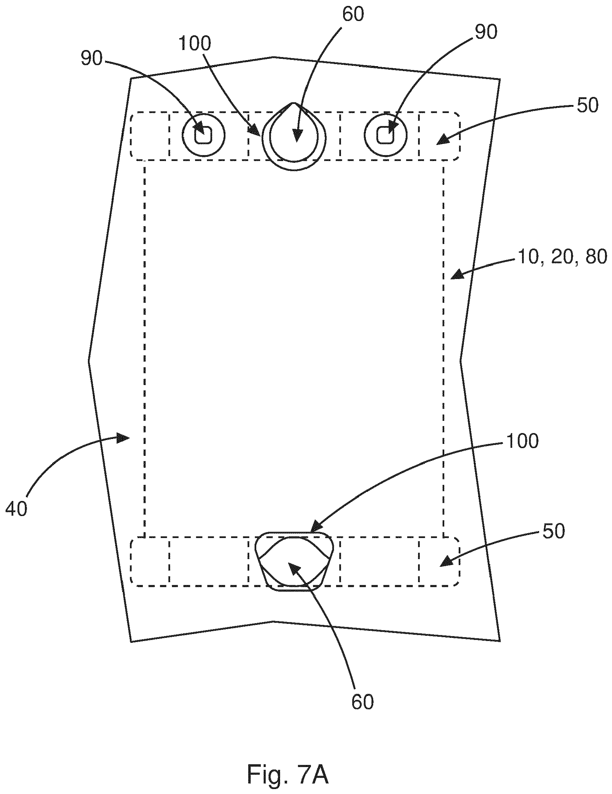

Fig. 7A shows a view of an exemplar current sensing device viewing a second surface of a substrate and where a coil element is mounted to a first surface of the substrate facing away from the viewer, with shaped locating pins and retaining holes of the substrate; and

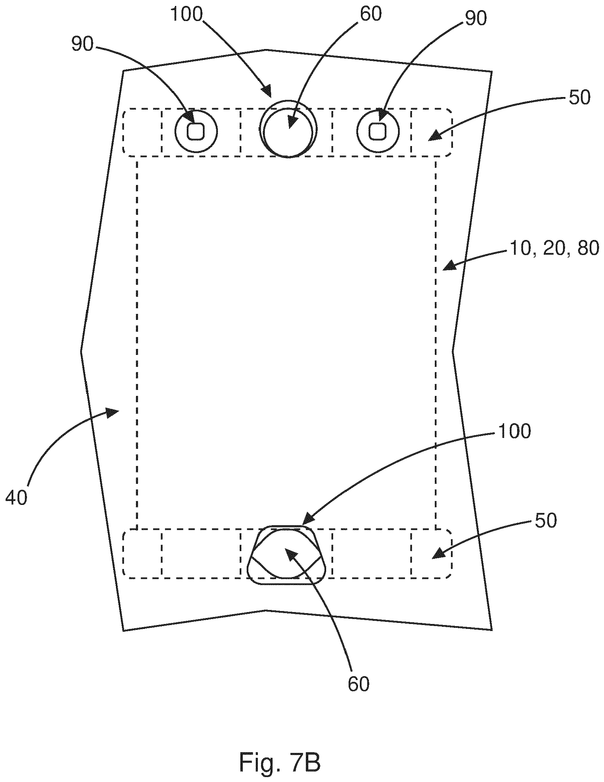

Fig. 7B shows a view of an exemplar current sensing device viewing a second surface of a substrate and where a coil element is mounted to a first surface of the substrate facing away from the viewer, with shaped locating pins and retaining holes of the substrate.

Thus, in summary of one or more of the detailed embodiments of the current sensing device are as follows:
A current sensing device comprises a plurality of coil elements mounted on a substrate. A coil element comprises a winding segment applied on a winding body, 2 flanges delimiting the winding segment, 2 connecting pins, and 2 locating pins being engaged in respective retaining holes of the substrate.

Each flange has a supporting edge configured to seat the coil element on the substrate and to ensure a predetermined spacing between the winding segment and the substrate.

A locating pin has at least one sharp positioning edge in touch with the inner wall of the retaining hole, forming a narrow touch surface.

The width of a narrow touch surface is much smaller than the circumference of the retaining hole.

A coil element is provided with 4 narrow touch surfaces configured to block the coil element in any direction in the plane of the substrate.

An engaged part comprises a small deformation, in particular the locating pin.

A hollow is provided between a locating pin, the nearest supporting edge, and the substrate. It can be a recess between the supporting edge and the locating pin.

The depth of a recess is comparable to the spacing between the supporting edges and the winding body.

2 narrow touch surfaces are provided at each flange, preferably at its outer side.

Each flange comprises a locating pin.

A locating pin is a protrusion from the flange being made of a same material.

A flange comprises a supporting edge at each lateral side and a connecting pin between each supporting edge and a locating pin.

The substrate is a PCB comprising electrical connections for the coil elements.

A connecting pin comprises a segment penetrating the winding body, a curved segment, and a segment directed to the PCB.

A 2nd PCB is provided to hold the coil elements between the 2 PCBS, and the PCBs are blocked with holding pins, which are preferably electrically connected to shielding planes of the PCBs.

The thickness of a flange is larger in the region of a locating pin than at a side of the flange.

## Claims

1. A current sensing device, comprising:
- a substrate (40); and
- one or more coil elements (30);
wherein the substrate comprises a plurality of holes (100) projecting at least part way through the substrate from a first surface of the substrate, wherein prior to a coil element being mounted to the substrate each of the plurality holes has a circular or polygonal cross section;
wherein the coil element comprises: a winding body (10, 20); a length of wire (80); and a plurality of locating pins (60);
wherein the winding body has an outer surface around an axis of the winding body, and wherein at least a portion of the length of wire is wound multiple times around the outer surface of the winding body in a generally circumferential direction with respect to the axis of the winding body;
wherein a first locating pin of the plurality of locating pins projects from the coil element in a direction parallel to a pin axis that is perpendicular to the axis of the winding body, and wherein a second locating pin of the plurality of locating pins projects from the coil element in the direction parallel to the pin axis;
wherein prior to the coil element being mounted to the substrate a cross section of the first locating pin perpendicular to the pin axis comprises first and second outer vertices facing away from the second locating pin, and a cross section of the second locating pin perpendicular to the pin axis comprises third and fourth outer vertices facing away from the first locating pin, and wherein the four outer vertices form a first quadrangle;
wherein when the coil element is mounted to the first surface of the substrate the first locating pin is located in a first hole of the plurality of holes such that the first and second outer vertices are in contact with first and second regions on the inside of the first hole and the second locating pin is located in a second hole of the plurality of holes such that the third and fourth outer vertices are in contact with third and fourth regions on the inside of the second hole; and
wherein prior to the coil element being mounted to the substrate, first and second circumferential or perimeter points of the first circular or polygonal cross section hole correlate with the first and second regions, and third and fourth circumferential or perimeter points of the second circular or polygonal cross section hole correlate with the third and fourth regions, and wherein the four circumferential or perimeter points form a second quadrangle smaller than the first quadrangle.

2. Current sensing device according to claim 1, wherein a third locating pin of the plurality of locating pins projects from the coil element in the direction parallel to the pin axis, wherein prior to the coil element being mounted to the substrate a cross section of the third locating pin perpendicular to the pin axis comprises fifth and sixth outer vertices facing away from the first locating pin, wherein the first and second and fifth and sixth outer vertices form a third quadrangle, wherein when the coil element is mounted to the first surface of the substrate the third locating pin is located in a third hole of the plurality of holes such that the fifth and sixth outer vertices are in contact with fifth and sixth regions on the inside of the third hole, wherein prior to the coil element being mounted to the substrate fifth and sixth circumferential or perimeter points of the third circular or polygonal cross section hole correlate with the fifth and sixth regions, wherein the first and second and fifth and sixth circumferential or perimeter points form a fourth quadrangle smaller than the third quadrangle.

3. Current sensing device according to claim 1, wherein a third locating pin of the plurality of locating pins projects from the coil element in the direction parallel to the pin axis, wherein prior to the coil element being mounted to the substrate a cross section of the third locating pin perpendicular to the pin axis comprises a fifth outer vertex facing away from the first locating pin, wherein the first and second and fifth outer vertices form a first triangle, wherein when the coil element is mounted to the first surface of the substrate the third locating pin is located in a third hole of the plurality of holes such that the fifth outer vertex is in contact with a fifth region on the inside of the third hole, wherein prior to the coil element being mounted to the substrate a fifth circumferential or perimeter point of the third circular or polygonal cross section hole correlates with the fifth region, wherein the first and second and fifth circumferential or perimeter points form a second triangle smaller than the first quadrangle.

4. Current sensing device according to any of claims 1-3, wherein the coil element comprises two flanges (50) located at either end of the winding body, and wherein when the coil element is mounted to the first surface of the substrate at least a portion (110) of each of the two flanges is in contact with the first surface of the substrate.

5. Current sensing device according to claim 4, wherein each flange comprises two supporting edges (110) at opposite ends of one side of the flange, and wherein when the coil element is mounted to the first surface of the substrate the two supporting edges of each flange are in contact with the first surface of the substrate.

6. Current sensing device according to any of claims 4-5, wherein the first locating pin of the plurality of locating pins is connected to or part of a first flange of the two flanges, and the second locating pin of the plurality of locating pins is connected to or part of a second flange of the two flanges.

7. Current sensing device according to claim 6, wherein the first flange comprises at least one recessed portion (120) adjacent to the first locating pin, and the second flange comprises at least one recessed portion (120) adjacent to the second locating pin, and wherein a surface of the flange within the recessed portion of each flange facing the first surface of the substrate is spaced from the first surface of the substrate.

8. Current sensing device according to any of claims 1-7, further comprising a second substrate, wherein the second substrate comprises a one or more holes projecting at least part way through the second substrate from a first surface of the second substrate, wherein prior to the coil element being mounted to the second substrate each of the one or more holes has a circular or polygonal cross section, wherein one or more further locating pins of the plurality of locating pins project from the coil element in the direction parallel to the pin axis, wherein when the coil element is mounted to the first surface of the substrate and mounted to the first surface of the second substrate the first surface of the substrate faces the first surface of the second substrate and the coil element is located between the substrate and the second substrate and the one or more further locating pins are located in the one or more holes of the second substrate.

9. Current sensing device according to any of claims 1-8, wherein when the coil element is mounted to the first surface of the substrate the first locating pin and the second locating pin have deformed the first circular or polygonal cross section hole and the second circular or polygonal cross section hole in the substrate; or wherein when the coil element is mounted to the first surface of the substrate the outer vertices of the first locating pin and the second locating pin have been deformed by the first circular or polygonal cross section hole and the second circular or polygonal cross section hole in the substrate.

10. Current sensing device according to any of claims 1-9, comprising a plurality of coil elements mounted to the substrate.

11. A current sensing device, comprising:
- a substrate (40); and
- one or more coil elements (30);
wherein the substrate comprises a plurality of holes (100) projecting at least part way through the substrate from a first surface of the substrate, wherein prior to a coil element being mounted to the substrate each of the plurality holes has a circular or polygonal cross section;
wherein the coil element comprises: a winding body (10, 20); a length of wire (80); and a plurality of locating pins (60);
wherein the winding body has an outer surface around an axis of the winding body, and wherein at least a portion of the length of wire is wound multiple times around the outer surface of the winding body in a generally circumferential direction with respect to the axis of the winding body;
wherein a first locating pin of the plurality of locating pins projects from the coil element in a direction parallel to a pin axis that is perpendicular to the axis of the winding body, and wherein a second locating pin of the plurality of locating pins projects from the coil element in the direction parallel to the pin axis;
wherein prior to the coil element being mounted to the substrate a cross section of the first locating pin perpendicular to the pin axis comprises first and second outer vertices facing away from the second locating pin, and a cross section of the second locating pin perpendicular to the pin axis comprises a third outer vertex facing away from the first locating pin, and wherein the three outer vertices form a first triangle;
wherein when the coil element is mounted to the first surface of the substrate the first locating pin is located in a first hole of the plurality of the holes such that the first and second outer vertices are in contact with first and second regions on the inside of the first hole and the second locating pin is located in a second hole of the plurality of holes such that the third outer vertex is in contact with a third region on the inside of the second cross section hole; and
wherein prior to the coil element being mounted to the substrate, first and second circumferential or perimeter points of the first circular or polygonal cross section hole correlate with the first and second regions, and a third circumferential or perimeter point of the second circular or polygonal cross section hole correlates with the third region, and wherein the three circumferential or perimeter points form a second triangle smaller than the first triangle.

12. A current sensing device, comprising:
- a substrate (40); and
- one or more coil elements (30);
wherein the substrate comprises a plurality of holes (100) projecting at least part way through the substrate from a first surface of the substrate, wherein prior to a coil element being mounted to the substrate each of the plurality holes has a circular or polygonal cross section;
wherein the coil element comprises: a winding body (10, 20); a length of wire (80); and a plurality of locating pins (60);
wherein the winding body has an outer surface around an axis of the winding body, and wherein at least a portion of the length of wire is wound multiple times around the outer surface of the winding body in a generally circumferential direction with respect to the axis of the winding body;
wherein a first locating pin of the plurality of locating pins projects from the coil element in a direction parallel to a pin axis that is perpendicular to the axis of the winding body, and wherein a second locating pin of the plurality of locating pins projects from the coil element in the direction parallel to the pin axis;
wherein prior to the coil element being mounted to the substrate a cross section of the first locating pin perpendicular to the pin axis comprises a first outer vertex facing away from the second locating pin, and a cross section of the second locating pin perpendicular to the pin axis comprises a second outer vertex facing away from the first locating pin, and wherein the two outer vertices form a first line;
wherein when the coil element is mounted to the first surface of the substrate the first locating pin is located in a first hole of the plurality of holes such that the first outer vertex is in contact with a first region on the inside of the first hole and the second locating pin is located in a second hole of the plurality of holes such that the second outer vertex is in contact with a second region on the inside of the second hole; and
wherein prior to the coil element being mounted to the substrate, a first circumferential or perimeter point of the first circular or polygonal cross section hole correlates with the first region, and a second circumferential or perimeter point of the second circular or polygonal cross section hole correlates with the second region, and wherein the two circumferential or perimeter points form a second line shorter than the first line.

13. A current sensing device, comprising:
- a substrate (40); and
- one or more coil elements (30);
wherein the substrate comprises a plurality of holes (100) projecting at least part way through the substrate from a first surface of the substrate, wherein prior to a coil element being mounted to the substrate each of the plurality holes has a circular or polygonal cross section;
wherein the coil element comprises: a winding body (10, 20); a length of wire (80); and a plurality of locating pins (60);
wherein the winding body has an outer surface around an axis of the winding body, and wherein at least a portion of the length of wire is wound multiple times around the outer surface of the winding body in a generally circumferential direction with respect to the axis of the winding body;
wherein a first locating pin of the plurality of locating pins projects from the coil element in a direction parallel to a pin axis that is perpendicular to the axis of the winding body, and wherein a second locating pin of the plurality of locating pins projects from the coil element in the direction parallel to the pin axis;
wherein prior to the coil element being mounted to the substrate a cross section of the first locating pin perpendicular to the pin axis comprises first and second inner vertices facing toward the second locating pin, and a cross section of the second locating pin perpendicular to the pin axis comprises third and fourth inner vertices facing toward the first locating pin, and wherein the four inner vertices form a first quadrangle;
wherein when the coil element is mounted to the first surface of the substrate the first locating pin is located in a first hole of the plurality of holes such that the first and second inner vertices are in contact with first and second regions on the inside of the first hole and the second locating pin is located in a second hole of the plurality of holes such that the third and fourth inner vertices are in contact with third and fourth regions on the inside of the second hole; and
wherein prior to the coil element being mounted to the substrate, first and second circumferential or perimeter points of the first circular or polygonal cross section hole correlate with the first and second regions, and third and fourth circumferential or perimeter points of the second circular or polygonal cross section hole correlate with the third and fourth regions, and wherein the four circumferential or perimeter points form a second quadrangle larger than the first quadrangle.

14. A current sensing device, comprising:
- a substrate (40); and
- one or more coil elements (30);
wherein the substrate comprises a plurality of holes (100) projecting at least part way through the substrate from a first surface of the substrate, wherein prior to a coil element being mounted to the substrate each of the plurality holes has a circular or polygonal cross section;
wherein the coil element comprises: a winding body (10, 20); a length of wire (80); and a plurality of locating pins (60);
wherein the winding body has an outer surface around an axis of the winding body, and wherein at least a portion of the length of wire is wound multiple times around the outer surface of the winding body in a generally circumferential direction with respect to the axis of the winding body;
wherein a first locating pin of the plurality of locating pins projects from the coil element in a direction parallel to a pin axis that is perpendicular to the axis of the winding body, and wherein a second locating pin of the plurality of locating pins projects from the coil element in the direction parallel to the pin axis;
wherein prior to the coil element being mounted to the substrate a cross section of the first locating pin perpendicular to the pin axis comprises first and second inner vertices facing toward the second locating pin, and a cross section of the second locating pin perpendicular to the pin axis comprises a third inner vertex facing toward the first locating pin, and wherein the three inner vertices form a first triangle;
wherein when the coil element is mounted to the first surface of the substrate the first locating pin is located in a first hole of the plurality of holes such that the first and second inner vertices are in contact with first and second regions on the inside of the first hole and the second locating pin is located in a second hole of the plurality of holes such that the third inner vertex is in contact with a third region on the inside of the second hole; and
wherein prior to the coil element being mounted to the substrate, first and second circumferential or perimeter points of the first circular or polygonal cross section hole correlate with the first and second regions, and a third circumferential or perimeter point of the second circular or polygonal cross section hole correlates with the third region, and wherein the three circumferential or perimeter points form a second triangle larger than the first triangle.

15. A current sensing device, comprising:
- a substrate (40); and
- one or more coil elements (30);
wherein the substrate comprises a plurality of holes (100) projecting at least part way through the substrate from a first surface of the substrate, wherein prior to a coil element being mounted to the substrate each of the plurality holes has a circular or polygonal cross section;
wherein the coil element comprises: a winding body (10, 20); a length of wire (80); and a plurality of locating pins (60);
wherein the winding body has an outer surface around an axis of the winding body, and wherein at least a portion of the length of wire is wound multiple times around the outer surface of the winding body in a generally circumferential direction with respect to the axis of the winding body;
wherein a first locating pin of the plurality of locating pins projects from the coil element in a direction parallel to a pin axis that is perpendicular to the axis of the winding body, and wherein a second locating pin of the plurality of locating pins projects from the coil element in the direction parallel to the pin axis;
wherein prior to the coil element being mounted to the substrate a cross section of the first locating pin perpendicular to the pin axis comprises a first inner vertex facing toward the second locating pin, and a cross section of the second locating pin perpendicular to the pin axis comprises a second inner vertex facing toward the first locating pin, and wherein the two inner vertices form a first line;
wherein when the coil element is mounted to the first surface of the substrate the first locating pin is located in a first hole of the plurality of holes such that the first inner vertex is in contact with a first region on the inside of the first hole and the second locating pin is located in a second hole of the plurality of holes such that the second inner vertex is in contact with a second region on the inside of the second hole; and
wherein prior to the coil element being mounted to the substrate, a first circumferential or perimeter point of the first circular or polygonal cross section hole correlates with the first region, and a second circumferential or perimeter point of the second circular or polygonal cross section hole correlates with the second region, and wherein the two circumferential or perimeter points form a second line longer than the first line.

16. A method of manufacturing a current sensing device comprising mounting the one or more coil elements to the substrate to provide the current sensing device according to any of claims 1-10; or a method of manufacturing a current sensing device comprising mounting the one or more coil elements to the substrate to provide the current sensing device according to any of claim 11; or a method of manufacturing a current sensing device comprising mounting the one or more coil elements to the substrate to provide the current sensing device according to any of claim 12; or a method of manufacturing a current sensing device comprising mounting the one or more coil elements to the substrate to provide the current sensing device according to any of claim 13; or a method of manufacturing a current sensing device comprising mounting the one or more coil elements to the substrate to provide the current sensing device according to any of claim 14; or a method of manufacturing a current sensing device comprising mounting the one or more coil elements to the substrate to provide the current sensing device according to any of claim 15.
